(19) Europäisches Patentamt
European Patent Office
Office européen des brevets

(11) EP 4 260 378 B1

(12) **EUROPEAN PATENT SPECIFICATION**

(45) Date of publication and mention of the grant of the patent:
**27.08.2025 Bulletin 2025/35**

(21) Application number: **21824431.7**

(22) Date of filing: **08.12.2021**

(51) International Patent Classification (IPC):
***H10F 19/30*** *(2025.01)* ***H10F 19/80*** *(2025.01)*
***H10F 19/85*** *(2025.01)* ***H10K 30/88*** *(2023.01)*

(52) Cooperative Patent Classification (CPC):
**H10F 19/80; H10F 19/30; H10F 19/85; H10K 30/88;**
Y02E 10/542

(86) International application number:
**PCT/IB2021/061454**

(87) International publication number:
**WO 2022/123456 (16.06.2022 Gazette 2022/24)**

(54) **BARRIER ASSEMBLY FOR SOLAR CELLS**

SPERRANORDNUNG FÜR SOLARZELLEN

ENSEMBLE BARRIÈRE POUR CELLULES SOLAIRES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.12.2020 US 202063122970 P**

(43) Date of publication of application:
**18.10.2023 Bulletin 2023/42**

(73) Proprietor: **3M Innovative Properties Company**
**Saint Paul, Minnesota 55133-3427 (US)**

(72) Inventors:
- **RULE, Joseph D.**
  **Saint Paul, Minnesota 55133-3427 (US)**
- **PIERPONT, Daniel M.**
  **Saint Paul, Minnesota 55133-3427 (US)**
- **WEIGEL, Mark D.**
  **Saint Paul, Minnesota 55133-3427 (US)**
- **JENNEN, Jay M.**
  **Saint Paul, Minnesota 55133-3427 (US)**

(74) Representative: **Mathys & Squire**
**Theatinerstraße 7**
**80333 München (DE)**

(56) References cited:
**US-A1- 2012 003 448**

- **KOJIO KEN ET AL: "Influence of chemical structure of hard segments on physical properties of polyurethane elastomers: a review", JOURNAL OF POLYMER RESEARCH, SPRINGER NETHERLANDS, DORDRECHT, vol. 27, no. 6, 7 May 2020 (2020-05-07), XP037188172, ISSN: 1022-9760, [retrieved on 20200507], DOI: 10.1007/S10965-020-02090-9**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Processed by Luminess, 75001 PARIS (FR)

## Description

### BACKGROUND

Emerging solar technologies such as organic photovoltaic devices (OPVs), and thin film solar cells like copper indium gallium di-selenide (CIGS) cells require protection from water vapor and need to be durable (e.g., to ultra-violet (UV) light) in outdoor environments. Typically, glass has been used as an encapsulating material for such solar devices because glass is a very good barrier to water vapor, is optically transparent, and is stable to UV light. However, glass is heavy, brittle, difficult to make flexible, and difficult to handle.

More recently, multilayer polymeric barrier assemblies comprising at least one fluoropolymer layer have been described in United States Patent 9,997,657. In these barrier assemblies, coefficient of thermal expansion (CTE) compensation is required between the fluoropolymer layer and the flexible carriers (e.g., polyester barrier films, polyimide films or metal foils) useful for photovoltaic cells. A similar barrier assembly for encapsulating solar cells is disclosed in US 2012/0003448 A1.

Additionally, emerging solar technologies, such as perovskites and dye-sensitized solar cells, provide semi-flexible and semi-transparent solar cells that can be used in applications not applicable to traditional glass-based systems. UV radiation, air infiltration and humidity can degrade the performance of dye-sensitized solar cells. Additionally, dye-sensitized solar cells include a liquid electrolyte solution that contains hazardous volatile organic compounds as solvents for the active dyes which can permeate through plastic materials if a suitable barrier material is not provided. Similarly, environmental stability due to oxygen, moisture and UV radiation are challenges to perovskite solar cells (PSCs). As a result, there is a need for barrier films to enable improved durability for these emerging solar cell technologies.

### SUMMARY

Despite progress in encapsulant technology, the barrier and durability requirements in solar applications continue to be a challenge, and further work is needed to bring effective, flexible encapsulating solutions to the solar market. The present disclosure provides assemblies useful, for example, for covering and protecting solar devices, especially flexible photovoltaic cells, such as dye-sensitized solar cells, perovskite solar cells, CIGS and OPV.

The barrier assemblies according to the present disclosure can improve the weatherability of flexible photovoltaic cells and are generally flexible, transmissive to visible and infrared light and generally lower cost than conventional barrier film solutions.

In a first embodiment, a solar cell assembly is described that comprises an exemplary barrier assembly disposed on or around a photovoltaic cell, wherein the barrier assembly comprises a barrier film and a polyurethane outer protective film layer bonded directly to an exposed major surface of the barrier film, wherein the barrier assembly disposed above the photovoltaic cell and the polyurethane outer protective film layer forms a top surface of the solar cell assembly that is exposed to incoming light. The polyurethane of the outer protective film layer has a hard segment content equal to or greater than 55 % relative to the overall weight of the polyurethane.

### BRIEF DESCRIPTION OF THE DRAWINGS

The disclosure may be more completely understood in consideration of the following detailed description of various embodiments of the disclosure in connection with the accompanying drawings, in which:

Fig. 1 illustrates a schematic side view of an embodiment of a prior art barrier assembly.
Fig. 2 is schematic cross section a first solar cell assembly comprising an exemplary barrier assembly according to the present disclosure.
Fig. 3 is a schematic cross section of a first embodiment of an exemplary barrier assembly according to the present disclosure.
Fig. 4 is a schematic cross section of a second embodiment of an exemplary barrier assembly according to the present disclosure.
Fig. 5 is schematic cross section of a portion of a second solar cell assembly comprising an exemplary barrier assembly according to the present disclosure.
Fig. 6 is schematic cross section of a portion of a third solar cell assembly comprising an exemplary barrier assembly according to the present disclosure.
Fig. 7 is schematic cross section of a portion of a fourth solar cell assembly comprising an exemplary barrier assembly according to the present disclosure.
Fig. 8 is schematic cross section of a portion of a fifth solar cell assembly comprising an exemplary barrier assembly according to the present disclosure.

DETAILED DESCRIPTION

In this application, terms such as "a", "an" and "the" are not intended to refer to only a singular entity but include the general class of which a specific example may be used for illustration. The terms "a", "an", and "the" are used interchangeably with the term "at least one". The phrases "at least one of" and "comprises at least one of" followed by a list refers to any one of the items in the list and any combination of two or more items in the list. All numerical ranges are inclusive of their endpoints and non-integral values between the endpoints unless otherwise stated.

Barrier films and barrier assemblies are needed for a variety of applications to protect electronic devices. Some included in the list are OLED devices, Electrophoretic Screens, and Solar devices. The barrier films described in this case are intended to protect these or other electronic devices from one or more of moisture and oxidation, while the complete barrier assembly can provide additional UV and mechanical protection to the barrier film and the solar cell beneath the barrier assembly.

Exemplary barrier assemblies, disclosed herein, comprise a barrier film and a polyurethane outer protective film layer bonded directly to exposed major surface of the barrier film. Polyurethane outer protective film layer is disposed on a front surface of a protected electronic device that is exposed to incoming light and the external environment (e.g. weather, moisture, air, dust, etc.).

In applications such as paint protective films or retroreflective flexible outdoor films, polyurethanes are used as the outward facing, weather resistant cover. Polyurethane films may be used as protective sheeting due to its abrasion resistance, toughness, flexibility, impact resistance, tear strength, and chemical resistance.

In other applications polyurethanes have been used as adhesives to bond one material to another material.

Barrier assemblies according to the present disclosure are transmissive to visible and infrared light. The term "transmissive to visible and infrared light" as used herein refers to having an average solar direct transmittance of at least about 75% (in some embodiments at least about 80, 85, 90, 92, or 95%) measured along the normal axis of the conductor sheet in the wavelength range of 300 nm to 2500 nm. Calculation of the solar direct transmittance is described in ISO9050. In some embodiments, the visible and infrared light-transmissive assembly has an average solar direct transmittance over a range of 350 nm to 1500 nm of at least about 75% (in some embodiments at least about 80, 85, 90, 92, or 95%). Visible and infrared light-transmissive assemblies are those that do not substantially interfere with absorption of visible and infrared light, for example, by photovoltaic cells. The materials used in the exemplary barrier assembly described herein can be selected based on refractive index and thickness to enhance transmission to visible and infrared light.

Barrier assemblies according to the present disclosure are typically flexible. The term "flexible" as used herein refers to being capable of being formed into a roll. In some embodiments, the term "flexible" refers to being capable of being bent around a roll core with a radius of curvature of up to 7.6 centimeters (cm) (3 inches), in some embodiments up to 6.4 cm (2.5 inches), 5 cm (2 inches), 3.8 cm (1.5 inch), or 2.5 cm (1 inch). Barrier assemblies of the present invention also typically exhibit high peel adhesion to EVA, and other common encapsulants for photovoltaic cells. The properties of the barrier assemblies disclosed herein typically are maintained even after high temperature and humidity aging.

Fig. 1 illustrates a prior art barrier assembly 10, such as UBF 512, a barrier film product available from 3M Company, that includes a barrier film 12, which can be described as having two major surfaces. On a first major surface, e.g., the lower major surface in the illustrated embodiment, the barrier film 12 is in contact with a polymeric film substrate 14. On a second major surface, e.g., the upper major surface in the illustrated embodiment, the barrier film 12 is in contact with a pressure sensitive adhesive layer 11, which adheres the barrier film 12 to a major surface of a protective film 13. The barrier film comprises first and second polymer layers 12a and 12c are separated by a visible light-transmissive inorganic barrier layer 12b. In an exemplary aspect, the protective film is a fluoropolymer film, such as ethylene-tetrafluoroethylene (ETFE) film, that is adhesively bonded to the upper major surface of the barrier film. UV stabilizers, such as ultraviolet absorbers (UVAs), Hindered Amine Light Stabilizers (HALS), and antioxidants, are often included in the adhesive used to bond the ETFE to the barrier assembly as a means of protecting the layers beneath the outer protective layer. While fluoropolymers are known for typically being resistant to UV degradation even in the absence of stabilizers such as UVA, HALS, and anti-oxidants, they are quite expensive and make barrier assemblies using them as the outer protective film too expensive for many consumer solar cell applications. Additionally, the adhesive used to bond the protection film to the substrate adds complexity and cost to the barrier assembly which can also be undesirable for low cost photovoltaics.

Thus, there is a need to simplify the construction of barrier film assemblies for photovoltaic devices both to streamline manufacturing and reduce the price points of the assemblies in order to access new developing photovoltaic device markets.

The exemplary barrier assemblies described herein replace the expensive ETFE and adhesive layers of barrier assembly 10 with a polyurethane outer protective film layer that is in direct contact with the top polymer layer in the barrier film, thus simplifying manufacture, reducing the cost of materials and thickness of the exemplary barrier assemblies described herein.

Many commercially available solar modules comprise an encapsulated array of individual interconnected photovoltaic cells arranged in a single plane beneath a front sheet of glass on the sun-facing side of the module and

a supporting substrate forming the bottom surface of the solar assembly.

In contrast, Fig. 2 shows a first exemplary solar cell assembly 50 of the current invention. Solar cell assembly comprises an array of photovoltaic cells (note: only a single photovoltaic cell 80 is illustrated in Fig. 2) disposed between a supporting substrate 60 and an exemplary barrier assembly 100. The barrier assemblies according to the present disclosure are useful, for example, for protecting photovoltaic/solar cells. In some embodiments, the assembly is disposed on, above, or around a photovoltaic cell. Accordingly, the present disclosure provides a method comprising applying an assembly 100 disclosed herein on the front side of a photovoltaic cell 80 at the top surface 51 of the solar cell assembly 50. Suitable solar cells include those that have been developed with a variety of materials each having a unique absorption spectrum that converts solar energy into electricity. Each type of semiconductor material will have a characteristic band gap energy which causes it to absorb light most efficiently at certain wavelengths of light, or more precisely, to absorb electromagnetic radiation over a portion of the solar spectrum.

The solar cell assembly may further comprise an encapsulant 75 at least partially surrounding the photovoltaic cell(s) 80. In the exemplary solar assembly shown in Fig. 2, the encapsulant 75 substantially surrounds the photovoltaic cell 80. Photovoltaic cell 80 may be a silicon solar cell, a copper indium gallium di-selenide (CIGS) solar cell, gallium arsenide (GaAs) solar cell, an organic photovoltaic (OPV) cell, a perovskite solar cell or a dye-sensitized solar cell, etc.

Supporting substrate 60 forms a bottom surface 52 of the solar cell assembly and is disposed beneath the photovoltaic cell. The supporting substrate may be a conventional backsheet material, a sheet of glass or an additional barrier assembly layer.

Barrier assembly 100 is disposed above the photovoltaic cell 80 and in direct contact with encapsulant 75. The barrier assembly comprises a barrier film 120 and a polyurethane outer protective film layer 130 bonded directly to an exposed major surface of the barrier film, such as through a lamination process, thus eliminating the need for a supplemental adhesive layer, such as a pressure sensitive adhesive. In this example embodiment, the barrier film 120 has an upper major surface and a lower major surface, as shown in the particular orientation of Fig. 2. Polyurethane outer protective film layer 130 forms a top surface 51 of the solar cell assembly 50 that is exposed to incoming light, $hv_I$. The barrier assembly further comprises a polymeric film substrate 140 beneath the barrier film and in direct contact with the encapsulant 75. The use of the exemplary barrier assembly, as described herein, to protect a solar cell eliminates the need for a front side glass sheet and the need for a supplemental bonding layer yielding a thinner, more cost effective, flexible barrier solution for some solar cell applications.

Advantageously, the exemplary barrier assembly can be used with moisture and oxygen sensitive thin film flexible solar cells (e.g. CIGS, OPV, die sensitized solar cells (DSSC), Perovskite, etc.) for consumer devices. Exemplary barrier assemblies of the present invention can have a total thickness of less than 11 mils (0.28 mm), preferably less than 8 mils (0.20 mm), preferably less than 6 mils (0.15 mm), more preferably about 4 mils (0.10 mm) or less.

Barrier assembly 100 is shown in more detail in Fig. 3. Barrier assembly 100 has polymeric film substrate 140 having first and second major surfaces 141, 142, a barrier film 120 disposed on the first major surface of the first polymeric film substrate; and a polyurethane outer protective film layer 130 disposed on the barrier film opposite the of polymeric film substrate. Barrier film 120 can comprise first and second polymer layers 122 and 124 disposed on either side of a visible light-transmissive inorganic barrier layer 126.

## Polymeric film substrate

Assemblies according to the present disclosure comprise a polymeric film substrate 140. In the context of polymeric films (e.g., first and second polymeric film substrates), the term "polymeric" will be understood to include organic homopolymers and copolymers, as well as polymers or copolymers that may be formed in a miscible blend, for example, by co-extrusion or by reaction, including transesterification. The terms "polymer" and "copolymer" include both random and block copolymers.

Polymeric film substrate 140 serves as a support onto which barrier film 120 can be deposited (e.g., using the methods described hereinbelow). In some embodiments, the polymeric film substrate can be heat-stabilized (e.g., using heat setting, annealing under tension, or other techniques) to minimize shrinkage up to at least the heat stabilization temperature when the polymeric film substrate is unconstrained. Substrates should provide sufficient mechanical strength such that they can be handled without breaking or stretching during the manufacturing process. For example, a polyurethane film would generally not provide sufficient mechanical strength and offer enough support unless an additional carrier web, such as a polyethylene terephthalate (PET) carrier web is applied prior to deposition of the barrier film. For cost sensitive consumer based solar applications requiring shorter service life times, exemplary suitable materials for the polymeric film substrate may preferably include polyethylene terephthalate (PET), polycarbonate (PC), polymethylmethacrylate (PMMA) and blends comprising less than 50% of a supplemental polymer, wherein the supplemental polymer can be selected from polyethylene naphthalate (PEN), polyetheretherketone (PEEK), polyaryletherketone (PAEK), polyarylate (PAR), polyetherimide (PEI), polyarylsulfone (PAS), polyethersulfone (PES), polyamideimide (PAI).

Polyesters such as PET are available, for example, from DuPont Teijin Films, Hopewell, VA or SKC, Inc.

(Covington, GA).

In an exemplary aspect, the first major surface of polymeric film substrate 140 can be treated to improve adhesion of barrier film 120. Similarly, second major surface of polymeric film substrate 140 can be treated to improve adhesion of the barrier assembly to the encapsulant of the photovoltaic/solar cell to which it will be bonded. Useful surface treatments include electrical discharge in the presence of a suitable reactive or non-reactive atmosphere (e.g., plasma, glow discharge, corona discharge, dielectric barrier discharge or atmospheric pressure discharge); chemical pretreatment; or flame pretreatment. A separate adhesion promotion layer may also be coated onto the major surface(s) of the polymeric film substrate to improve adhesion. The adhesion promotion layer can be, for example, a separate polymeric layer or a metal-containing layer such as a layer of metal, metal oxide, metal nitride or metal oxynitride. The adhesion promotion layer may have a thickness of a few nanometers (e.g., 1 or 2 nm) to about 50 nm or more, or up to about 2 microns. In some embodiments, the first major surface of the polymeric film substrate can be treated to enhance adhesion to the barrier film, and the second major surface can be treated to enhance adhesion to a device to be covered or an encapsulant (e.g., EVA) that covers the photovoltaic cell. Some commercially available surface treated polymeric film substrate s that can be useful in the exemplary barrier assembly are commercially available from DuPont Teijin. For some of these films, both sides are surface treated (e.g., with the same or different pretreatments), and for others, only one side is surface treated.

In some embodiments, the polymeric film substrate 140 can have a thickness from 12 μm to 150 μm, preferably from 25 μm to 125μm.

Barrier Film

Barrier films 120 useful for practicing the present disclosure can be selected from a variety of constructions. The term "barrier film" refers to films that provide a barrier to at least one of oxygen or water. Barrier films are typically selected such that they have oxygen and water transmission rates at a specified level as required by the application. In some embodiments, the barrier film has a water vapor transmission rate (WVTR) less than about 0.005 $g/m^2$/day at 38°C and 100% relative humidity; in some embodiments, less than about 0.0005 $g/m^2$/day at 38°C and 100% relative humidity; and in some embodiments, less than about 0.00005 $g/m^2$/day at 38°C and 100% relative humidity. In some embodiments, the flexible barrier film has a WVTR of less than about 0.05, 0.005, 0.0005, or 0.00005 $g/m^2$/day at 50°C and 100% relative humidity or even less than about 0.005, 0.0005, 0.00005 $g/m^2$/day at 85°C and 100% relative humidity. In some embodiments, the barrier film has an oxygen transmission rate of less than about 0.005 $g/m^2$/day at 23°C and 90% relative humidity; in some embodiments, less than about 0.0005 $g/m^2$/day at 23°C and 90% relative humidity; and in some embodiments, less than about 0.00005 $g/m^2$/day at 23°C and 90% relative humidity.

Exemplary barrier film may consist of an inorganic oxide layer disposed between first and second polymer layers, wherein the first and second polymer layers each comprise a polymeric reaction product of at least one of acrylic or methacrylic monomers, wherein the inorganic oxide layer can be prepared by atomic layer deposition, thermal evaporation, sputtering, and chemical vapor deposition. Useful barrier films are typically flexible and transparent.

As mentioned previously, barrier film 120 comprises first and second polymer layers 122 and 124 disposed on either side of a visible light-transmissive inorganic barrier layer 126.

The first and second polymer layers 122, 124 can independently be formed by applying a layer of a monomer or oligomer and crosslinking the layer to form the polymer in situ, for example, by flash evaporation and vapor deposition of a radiation-crosslinkable monomer followed by crosslinking, for example, using an electron beam apparatus, UV light source, electrical discharge apparatus or other suitable device. The first polymer layer 122 is applied, for example, to the polymeric film substrate , and the second polymer layer is typically applied to the inorganic barrier layer. The materials and methods useful for forming the first and second polymer layers may be independently selected to be the same or different.

Useful techniques for flash evaporation and vapor deposition followed by crosslinking in situ can be found, for example, in U.S. Patent Nos. 4,696,719 (Bischoff), 4,722,515 (Ham), 4,842,893 (Yializis et al.), 4,954,371 (Yializis), 5,018,048 (Shaw et al.), 5,032,461(Shaw et al.), 5,097,800 (Shaw et al.), 5,125,138 (Shaw et al.), 5,440,446 (Shaw et al.), 5,547,908 (Furuzawa et al.), 6,045,864 (Lyons et al.), 6,231,939 (Shaw et al.) and 6,214,422 (Yializis); in published PCT Application No. WO 00/26973 (Delta V Technologies, Inc.); in D. G. Shaw and M. G. Langlois, "A New Vapor Deposition Process for Coating Paper and Polymer Webs", 6th International Vacuum Coating Conference (1992); in D. G. Shaw and M. G. Langlois, "A New High Speed Process for Vapor Depositing Acrylate Thin Films: An Update", Society of Vacuum Coaters 36th Annual Technical Conference Proceedings (1993); in D. G. Shaw and M. G. Langlois, "Use of Vapor Deposited Acrylate Coatings to Improve the Barrier Properties of Metallized Film", Society of Vacuum Coaters 37th Annual Technical Conference Proceedings (1994); in D. G. Shaw, M. Roehrig, M. G. Langlois and C. Sheehan, "Use of Evaporated Acrylate Coatings to Smooth the Surface of Polyester and Polypropylene Film Substrates", RadTech (1996); in J. Affinito, P. Martin, M. Gross, C. Coronado and E. Greenwell, "Vacuum deposited polymer/metal multilayer films for optical application", Thin Solid Films 270, 43 - 48 (1995); and in J.D. Affinito, M. E. Gross, C. A. Coronado, G. L. Graff, E. N. Greenwell and P. M. Martin, "Polymer-Oxide Transparent Barrier Layers", Society of Vacuum Coaters 39th Annual Technical Conference Proceedings (1996). In some embodiments, the polymer layers and inorganic barrier layer

are sequentially deposited in a single pass vacuum coating operation with no interruption to the coating process.

The coating efficiency of the first polymer layer 122 can be improved, for example, by cooling the polymeric film substrate 140. Similar techniques can also be used to improve the coating efficiency of the second polymer layer 124. The monomer or oligomer useful for forming the first and/or second polymer layers can also be applied using conventional coating methods such as roll coating (e.g., gravure roll coating) or spray coating (e.g., example, electrostatic spray coating). The first and/second polymer layers can also be formed by applying a layer containing an oligomer or polymer in solvent and then removing the solvent using conventional techniques (e.g., at least one of heat or vacuum). Plasma polymerization may also be employed.

Volatilizable acrylate and methacrylate monomers are useful for forming the first and second polymer layers. In some embodiments, volatilizable acrylates are used. Volatilizable acrylate and methacrylate monomers may have a molecular weight in the range from about 150 to about 600 grams per mole, or, in some embodiments, from about 200 to about 400 grams per mole. In some embodiments, volatilizable acrylate and methacrylate monomers have a value of the ratio of the molecular weight to the number of (meth)acrylate functional groups per molecule in the range from about 150 to about 600 g/mole/(meth)acrylate group, in some embodiments, from about 200 to about 400 g/mole/(meth)acrylate group. Fluorinated acrylates and methacrylates can be used at higher molecular weight ranges or ratios, for example, about 400 to about 3000 molecular weight or about 400 to about 3000 g/mole/(meth)acrylate group. Exemplary useful volatilizable acrylates and methacrylates include hexanediol diacrylate, ethoxyethyl acrylate, phenoxyethyl acrylate, cyanoethyl (mono)acrylate, isobornyl acrylate, isobornyl methacrylate, octadecyl acrylate, isodecyl acrylate, lauryl acrylate, beta-carboxyethyl acrylate, tetrahydrofurfuryl acrylate, dinitrile acrylate, pentafluorophenyl acrylate, nitrophenyl acrylate, 2-phenoxyethyl acrylate, 2-phenoxyethyl methacrylate, 2,2,2-trifluoromethyl (meth)acrylate, diethylene glycol diacrylate, triethylene glycol diacrylate, triethylene glycol dimethacrylate, tripropylene glycol diacrylate, tetraethylene glycol diacrylate, neopentyl glycol diacrylate, propoxylated neopentyl glycol diacrylate, polyethylene glycol diacrylate, tetraethylene glycol diacrylate, bisphenol A epoxy diacrylate, 1,6-hexanediol dimethacrylate, trimethylol propane triacrylate, ethoxylated trimethylol propane triacrylate, propylated trimethylol propane triacrylate, tris(2-hydroxyethyl)isocyanurate triacrylate, pentaerythritol triacrylate, phenylthioethyl acrylate, naphtholoxyethyl acrylate, cyclic diacrylates (for example, EB-130 from Cytec Industries Inc. and tricyclodecane dimethanol diacrylate, available as SR833S from Sartomer Co.), epoxy acrylate RDX80095 from Cytec Industries Inc., and mixtures thereof.

Useful monomers for forming the first and second polymer layers are available from a variety of commercial sources and include urethane acrylates (e.g., available from Sartomer Co., Exton, PA under the trade designations "CN-968" and "CN-983"), isobornyl acrylate (e.g., available from Sartomer Co. under the trade designation "SR-506"), dipentaerythritol pentaacrylates (e.g., available from Sartomer Co. under the trade designation "SR-399"), epoxy acrylates blended with styrene (e.g., available from Sartomer Co. under the trade designation "CN-120S80"), ditrimethylolpropane tetraacrylates (e.g., available from Sartomer Co. under the trade designation "SR-355"), diethylene glycol diacrylates (e.g., available from Sartomer Co. under the trade designation "SR-230"), 1,3-butylene glycol diacrylate (e.g., available from Sartomer Co. under the trade designation "SR-212"), pentaacrylate esters (e.g., available from Sartomer Co. under the trade designation "SR-9041"), pentaerythritol tetraacrylates (e.g., available from Sartomer Co. under the trade designation "SR-295"), pentaerythritol triacrylates (e.g., available from Sartomer Co. under the trade designation "SR-444"), ethoxylated (3) trimethylolpropane triacrylates (e.g., available from Sartomer Co. under the trade designation "SR-454"), ethoxylated (3) trimethylolpropane triacrylates (e.g., available from Sartomer Co. under the trade designation "SR-454HP"), alkoxylated trifunctional acrylate esters (e.g., available from Sartomer Co. under the trade designation "SR-9008"), dipropylene glycol diacrylates (e.g., available from Sartomer Co. under the trade designation "SR-508"), neopentyl glycol diacrylates (e.g., available from Sartomer Co. under the trade designation "SR-247"), ethoxylated (4) bisphenol a dimethacrylates (e.g., available from Sartomer Co. under the trade designation "CD-450"), cyclohexane dimethanol diacrylate esters (e.g., available from Sartomer Co. under the trade designation "CD-406"), isobornyl methacrylate (e.g., available from Sartomer Co. under the trade designation "SR-423 "), cyclic diacrylates (e.g., available from UCB Chemical, Smyrna, GA, under the trade designation "IRR-214") and tris (2-hydroxy ethyl) isocyanurate triacrylate (e.g., available from Sartomer Co. under the trade designation "SR-368"), acrylates of the foregoing methacrylates and methacrylates of the foregoing acrylates.

Other useful monomers may include di(meth)acrylate monomers described in U.S. Patent Publication Nos. 2018/0236756, 2018/0136755 and 2018/0244881, herein incorporated by reference in their entirety.

Other monomers that are useful for forming the first and/or second polymer layers include vinyl ethers, acrylonitrile, and mixtures thereof.

The desired chemical composition and thickness of the first polymer layer 122 will depend in part on the nature and surface topography of the polymeric film substrate 140. The thickness of the first and/or second polymer layers will typically be sufficient to provide a smooth, defect-free surface to which inorganic barrier layer 126 can be applied subsequently. For example, the first polymer layer may have a thickness of a few nm (for example, 2 or 3 nm) to about 5 micrometers or more. The thickness of the second polymer layer may also be in this range and may, in some embodiments, be thinner than the first polymer layer.

Inorganic barrier layer 126 can be formed from a variety of materials. Useful materials include metals, metal oxides, metal nitrides, metal carbides, metal oxynitrides, metal oxyborides, and combinations thereof. Exemplary metal oxides include silicon oxides such as silica, aluminum oxides such as alumina, titanium oxides such as titania, indium oxides, tin oxides, indium tin oxide (ITO), tantalum oxide, zirconium oxide, niobium oxide, and combinations thereof. Other exemplary materials include boron carbide, tungsten carbide, silicon carbide, aluminum nitride, silicon nitride, boron nitride, aluminum oxynitride, silicon oxynitride, boron oxynitride, zirconium oxyboride, titanium oxyboride, and combinations thereof. In some embodiments, the inorganic barrier layer comprises at least one of ITO, silicon oxide, or aluminum oxide. In some embodiments, with the proper selection of the relative proportions of each elemental constituent, ITO can be electrically conductive. The inorganic barrier layers can be formed, for example, using techniques employed in the film metallizing art such as sputtering (for example, cathode or planar magnetron sputtering, dual AC planar magnetron sputtering or dual AC rotatable magnetron sputtering), evaporation (for example, resistive or electron beam evaporation and energy enhanced analogs of resistive or electron beam evaporation including ion beam and plasma assisted deposition), chemical vapor deposition, plasma-enhanced chemical vapor deposition, and plating. **In** some embodiments, the inorganic barrier layers are formed using sputtering, for example, reactive sputtering. Enhanced barrier properties may be observed when the inorganic layer is formed by a high energy deposition technique such as sputtering compared to lower energy techniques such as conventional vapor deposition processes. Without being bound by theory, it is believed that the enhanced properties are due to the condensing species arriving at the substrate with greater kinetic energy, leading to a lower void fraction as a result of compaction.

The desired chemical composition and thickness of each inorganic barrier layer will depend in part on the nature and surface topography of the underlying layer and on the desired optical properties for the barrier film. The inorganic barrier layers typically are sufficiently thick so as to be continuous, and sufficiently thin so as to ensure that the barrier films and assemblies disclosed herein will have the desired degree of visible light transmission and flexibility. The physical thickness (as opposed to the optical thickness) of each inorganic barrier layer may be, for example, about 3 nm to about 150 nm (in some embodiments, about 4 nm to about 75 nm). The inorganic barrier layer typically has an average transmission over the visible portion of the spectrum of at least about 75% (in some embodiments at least about 80, 85, 90, 92, 95, 97, or 98%) measured along the normal axis. **In** some embodiments, the inorganic barrier layer has an average transmission over a range of 400 nm to 1400 nm of at least about 75% (in some embodiments at least about 80, 85, 90, 92, 95, 97, or 98%). Useful inorganic barrier layers typically are those that do not interfere with absorption of visible or infrared light, for example, by photovoltaic cells.

Additional inorganic barrier layers and polymer layers can be present if desired. **In** embodiments wherein more than one inorganic barrier layer is present, the inorganic barrier layers do not have to be the same or have the same thickness. When more than one inorganic barrier layer is present, the inorganic barrier layers can respectively be referred to as the "first inorganic barrier layer" and "second inorganic barrier layer". Additional "polymer layers" may be present in between additional inorganic barrier layers. For example, the barrier film may have several alternating inorganic barrier layers and polymer layers. Each unit of inorganic barrier layer combined with a polymer layer is referred to as a dyad, and the barrier film can include any number of dyads. It can also include various types of optional layers between the dyads.

Surface treatments or tie layers can be applied between any of the polymer layers or inorganic barrier layers, for example, to improve smoothness or adhesion. Useful surface treatments include electrical discharge in the presence of a suitable reactive or non-reactive atmosphere (e.g., plasma, glow discharge, corona discharge, dielectric barrier discharge or atmospheric pressure discharge); chemical pretreatment; or flame pretreatment. Exemplary useful tie layers include a separate polymeric layer or a metal-containing layer such as a layer of metal, metal oxide, metal nitride or metal oxynitride. The tie layer may have a thickness of a few nanometers (nm) (e.g., 1 or 2 nm) to about 50 nm or more.

**In** some embodiments, adhesion of the polyurethane outer protective layer 130 to the top polymer layer 124 in the barrier film 120 may be enhanced forming a chemical bond between the polyurethane outer protective layer and the top polymer layer by incorporating a coupling agent into the top polymer layer of the barrier film.

**In** some embodiments, one of the polymer layers (e.g., the second polymer layer) in the barrier film can be formed from co-depositing coupling agent such as a silane (e.g., an amino silane, cyclic azasilane or a urethane (multi)-(meth) acrylate (multi)-silane) and a radiation-curable monomer (e.g., any of the acrylates listed above). The presence of silanes with reactive groups can form chemical linkages to the polyurethane outer protective layer. Exemplary barrier films may comprise up to 20 wt.%, preferably up to 15 wt.%, of a coupling agent in the second polymer layer to enhance the adhesion of the polyurethane outer protective layer to the surface of the second polymer layer. In some embodiments, the exemplary coupling agent will be a vapor depositable, multifunctional material capable of reacting with the monomers in the second polymer layer. In some aspects, the coupling agent will be a urethane (multi)-(meth)acrylate (multi)-silane having a high glass transition temperature wherein at least a portion of the urethane segments will be disposed at the exposed surface of the second polymer layer. The presence of the urethane segments at the surface of the second polymer layer will be available to form chemical bonds with the polyurethane outer protective film layer.

Co-depositing includes co-evaporating and evaporating a mixture of the silane and the monomer. Cyclic azasilanes are ring compounds, wherein at least one of the ring members is a nitrogen and at least one of the ring

members is a silicon, and wherein the ring contains at least one nitrogen-to-silicon bond. **In** some embodiments, the cyclic azasilane is represented by the general formula

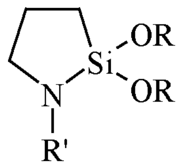

In other embodiments, the cyclic azasilane is represented by the general formula

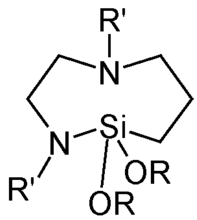

In either of these embodiments, each R is independent alkyl having up to 12, 6, 4, 3, or 2 carbon atoms and R' is hydrogen, alkyl, or alkenyl with alkyl and alkenyl each having up to 12, 6, 4, 3, or 2 carbon atoms and optionally substituted by amino. Exemplary cyclic azasilanes include 2,2-dimethoxy-N-butyl-1-aza-2-silacyclopentane, 2-methyl-2-methoxy-N-(2-aminoethyl)-1-aza-2-silacyclopentane, 2,2-diethoxy-N-(2-aminoethyl)-1-aza-2-silacyclopentane, 2,2-dimethyl-N-allyl-1-aza-2-silacyclopentane, 2,2-dimethoxy-N-methyl-1-aza-2-silacyclopentane, 2,2-diethoxy-1-aza-2-silacyclopentane, 2,2-dimethoxy-1,6-diaza-2-silacyclooctane, and N-methyl-1-aza-2,2,4-trimethylsilacyclopentane. When the cyclic azasilane is placed in the presence of a hydroxyl (e.g., silanol) group it quickly reacts to form a Si-O-Si (siloxane) linkage from the oxide surface to the co-condensed pre-polymer while the nitrogen moiety becomes a reactive amine on the other end of the molecule that can bond with pre-polymer compound(s) during polymerization. Amino silanes, which have the general formula

$$HZN\text{-}L\text{-}SiY_xY'_{3-x},$$

wherein Z is hydrogen or alkyl having up to 12 carbon atoms, L is alkylene having up to 12 carbon atoms, Y is a hydrolysable group (e.g., alkoxy having up to 12 carbon atoms or halogen), and Y' is a non-hydrolysable group (e.g., alkyl having up to 12 carbon atoms) have silane groups capable of forming siloxane bond with a metal oxide surface and amino groups capable of reacting with polymerizable compounds (e.g., acrylates). Exemplary amino silanes include (e.g., 3-aminopropyltrimethoxysilane; 3-aminopropyltriethoxysilane; 3-(2-aminoethyl)aminopropyltrimethoxysilane; N-(2-aminoethyl)-3-aminopropylmethyldimethoxysilane, bis-(gamma-triethoxysilylpropyl)amine; N-(2-aminoethyl)-3-aminopropyltributoxysilane; 6-(aminohexylaminopropyl)trimethoxysilane; 4-aminobutyltrimethoxysilane; 4-aminobutyltriethoxysilane; 3-aminopropyltris(methoxyethoxyethoxy)silane; 3-aminopropylmethyldiethoxysilane; 3-(N-methylamino)propyltrimethoxysilane; 3-(N-ethylamino)propyltrimethoxysilane; 3-(N-propylamino)propyltrimethoxysilane; 3-(N-butylamino)propyltrimethoxysilane; N-(2-aminoethyl)-3-aminopropylmethyldimethoxysilane; N-(2-aminoethyl)-3-aminopropylmethyldiethoxysilane; N-(2-aminoethyl)-3-aminopropyltrimethoxysilane; N-(2-aminoethyl)-3-aminopropyltriethoxysilane; 3-aminopropylmethyldiethoxysilane; 3-aminopropylmethyldimethoxysilane; 3-aminopropyldimethylmethoxysilane; and 3-aminopropyldimethylethoxysilane). Accordingly, in some embodiments, the barrier film comprises an inorganic layer that shares a chemical bond (e.g., a siloxane bond) with one or more organic layers. For example, a hydroxyl group derived from a metal oxide can react with a silane group on an amino silane or cyclic azasilane. The amount of water vapor present in a multi-process vacuum chamber, for example, can be controlled to promote the formation of such hydroxyl groups in high enough surface concentration to provide increased bonding sites. With residual gas monitoring and the use of water vapor sources, for example, the amount of water vapor in a vacuum chamber can be controlled to ensure adequate generation of hydroxyl (e.g., Si-OH) groups. An exemplary barrier material comprising a aminosilane in the second polymer layer is 3M™ Flexible Transparent Barrier (FTB3-50) Film, available from 3M Company (St. Paul, MN, USA).

In some embodiments, the coupling agent can be a urethane (multi)-(meth)acrylate (multi)-silane precursor compound of the formula $R_S$-N(H)-C(O)-O-$R_A$ or -$R_S$-O-C(O)-N(H)-$R_A$. $R_S$ is a silane containing group of the formula -$R^1$-[Si($Y_p$)($R^2$)$_{3-p}$]$_q$, in which $R^1$ is a multivalent alkylene, arylene, alkarylene, or aralkylene group, said alkylene, arylene, alkarylene, or aralkylene groups optionally containing one or more catenary oxygen atoms, each Y is a hydrolysable group, $R^2$ is a monovalent alkyl or aryl group; p is 1, 2, or 3, and q is 1-5. $R_A$ is a (meth)acryl group containing group of the formula

$R^{11}$-$(A)_n$, in which $R^{11}$ is a polyvalent alkylene, arylene, alkarylene, or aralkylene group, said alkylene, arylene, alkarylene, or aralkylene groups optionally containing one or more catenary oxygen atoms, A is a (meth)acryl group comprising the formula $X^2$-C(O)-C($R^3$)=$CH_2$, in which $X^2$ is -O, -S, or -$NR^3$, $R^3$ is H, or $C_1$-$C_4$, and n=1 to 5.

In an exemplary aspect, the coupling agent can be a silane formed from a multifunctional urethane acrylate, such as is described in U.S. Patent No. 9,790,396, herein incorporated by reference in its entirety, can be used. An exemplary barrier material comprising a urethane (multi)-(meth)acrylate (multi)-silane precursor compound in the second polymer layer is 3M™ Ultra Barrier Film (UBF-5) available from 3M Company (St. Paul, MN, USA).

With the addition of silanes, the peel strength of the coating can be improved, and peel strength adhesion is retained after exposure to high heat and humidity conditions. Additionally, the addition of silane eliminates the need for a tie layer, which greatly simplifies the coating process and barrier coating stack construction. The resulting barrier coatings retain high barrier properties and optical transmission performance. For additional details on barrier films containing cyclic azasilanes, see, for example, U.S. Patent No. 10,227,688, or for barrier films containing amino-functional silane, see for example U.S. Patent Publication No. 2015/0194541, both of which are incorporated by reference herein in their entirety.

## Polyurethane outer protective film layer

As already mentioned, the exemplary barrier assemblies 100 include a polyurethane outer protective film layer 130 configured to be disposed on the outward surface of an electronic device wherein the polyurethane of the outer protective film layer has a hard segment content equal to or greater than 55 % relative to the overall weight of the polyurethane. **In** some exemplary embodiments, the polyurethane outer protective layer can comprise various thermosetting or thermoplastic urethane polymers. The polyurethane polymeric protection layer may be a single layer or multilayer polyurethane film. In some embodiments, the polyurethane outer protective film layer can have a thickness from 5 to 150 μm, preferably from 25 to 75 μm.

In some exemplary embodiments, the barrier assembly may be visible light-transmissive. Thus, the polyurethane outer protective film layer also be visibly transmissive to at least about 50%, 60%, 70%, 80%, 90% or even up to about 100% at 550 nm.

Chemically, polyurethanes are distinguished by their characteristic carbamate (-NH-CO-O-) linkages and are generally prepared by reacting a polyisocyanate with a polyol in the presence of a catalyst. Suitable polyurethanes can be thermoset polyurethanes or thermoplastic polyurethanes. Thermoset polyurethanes are highly crosslinked by covalent bonds.

Thermoplastic polyurethanes are characterized by segmented polymeric chains having self-ordering block structures that are generally uncrosslinked. The predominately linear polymeric chains of a thermoplastic polyurethane generally contain low-polarity "soft segments" derived from long-chain polyols. The soft segments provide a continuous matrix that enables facile elongation of the polyurethane material. The soft segment portion may or may not be the majority phase of the polyurethane composition. The predominately linear polymeric chains of a thermoplastic polyurethane also generally contain high-polarity "hard segments" derived from polyisocyanates and short-chain polyols classified as chain extenders. The hard segments aggregate to form crystalline or pseudo-crystalline regions that act like physical crosslinks at ambient temperatures accounting for the elasticity of the thermoplastic polyurethane. The hard segments dissociate upon heating, and as a result, thermoplastic polyurethanes are melt-processible and can be easily reprocessed.

In some embodiments, the soft and hard segments are synthesized in a one-step reaction that includes a polyisocyanate, short-chain polyol, and long-chain polyol. In some embodiments, the long-chain polyol and polyisocyanate are first reacted to form a prepolymer, and that prepolymer is subsequently reacted with the short-chain polyol or chain extender to form a high molecular weight polymer.

The overall molecular weight of the thermoplastic polyurethane after polymerization should be sufficiently high to provide a durable protective layer capable of imparting scratch and gouge resistance along with resistance to solvents such as ethanol even after weathering, yet not so high that melt processing of the polymer is unduly complicated. In exemplary embodiments, thermoplastic polyurethane can have a weight average molecular weight of at least 30,000 g/mol, at least 60,000 g/mol, at least 100,000 g/mol, at least 150,000 g/mol, at least 200,000 g/mol, at least 250,000 g/mol, at least 300,000 g/mol, or at least 400,000 g/mol. In exemplary embodiments, the aliphatic thermoplastic polyurethane can have a weight average molecular weight of at most 800,000 g/mol, at most 500,000 g/mol, at most 400,000 g/mol, at most 300,000 g/mol, or at most 200,000 g/mol. In some embodiments, weight average molecular weights in the range of 60,000 g/mol to 300,000 g/mol can simultaneously provide good toughness and weatherability properties while still having good processability.

A wide variety of polyisocyanates may be used. The term polyisocyanate includes isocyanate-functional materials that generally comprise at least 2 terminal isocyanate groups, such as diisocyanates that may be generally described by the structure OCN-Z- NCO, where the Z group may be an aliphatic group, an aromatic group, or a group containing a combination of aromatic and aliphatic groups. Polyurethanes can generally be classified as aromatic polyurethanes or aliphatic polyurethanes based on which type of polyisocyanate is used.

For outdoor applications, aliphatic polyurethanes are generally preferred over aromatic polyurethanes due to the improved UV stability of aliphatic polyurethanes. Aromatic polyurethanes tend to contain chromophores often interact with the light and therefore are less stable and can discolor quickly outdoors.

An aliphatic thermoplastic polyurethane layer is synthesized by polymerizing a polyol and an aliphatic polyisocyanate. Examples of suitable aliphatic polyisocyanates include, for example, aliphatic diisocyanates such as such as 1,4-diisocyanatobutane, 1,6-diisocyanatohexane, 1,12-diisocyanatododecane, 2-methyl-1,5-diisocyanatopentane, and cycloaliphatic diisocyanates such as methylene-dicyclohexylene-4,4'-diisocyanate, methylene-dicyclohexylene-2,4'-diisocyanate, and 3-isocyanatomethyl-3,5,5-trimethyl-cyclohexyl isocyanate (isophorone diisocyanate). For reasons of weatherability, generally aliphatic and cycloaliphatic diisocyanates are used.

In the production of polyurethanes, a wide variety of polyols may be used. The term polyol includes hydroxyl-functional materials that generally comprise at least 2 terminal hydroxyl groups and may be generally described by the structure HO-B-OH, where the B group may be an aliphatic group, an aromatic group, or a group containing a combination of aromatic and aliphatic groups. Additionally, the B group may contain a variety of linkages or functional groups, including ester linkages, ether linkages polycarbonate linkages and additional terminal hydroxyl groups, to name a few. Typically, the HO-B-OH is a diol or a hydroxyl-capped prepolymer. Exemplary hydroxyl-capped prepolymer may comprise a polyurethane, polyester, polyamide, silicone, acrylic, polyurea, or polycarbonate as the B group in the prepolymer.

Examples of useful polyols include, but are not limited to, polyester polyols (such as lactone polyols), polyether polyols (such as polyoxyalkylene polyols), polycarbonate, polyalkylene polyols, mixtures thereof, and copolymers therefrom. Among polyester polyols, there are linear and non-linear polyester polyols including, for example, those made from polyethylene adipate, polybutylene adipate, polyhexamethylene adipate, polydiethylene adipate, polybutylene succinate, polyhexamethylene sebacate, polyhexamethylene dodecanedioate, polyneopentyl adipate, polypropylene adipate, polycyclohexanedimethyl adipate, and poly ε-caprolactone.

Examples of suitable polyether polyols can include linear and non-linear polyether polyols including, for example, those made from polyethylene glycol, polypropylene glycol, and polytetramethylene ether glycol (PTMEG) and copolymers thereof. In some embodiments, polyurethanes derived from PTMEG can provide superior physical properties such as strength. In some embodiments, polyether polyols and ether polyurethanes are preferred over polyester polyols and ester polyurethanes. Urethanes derived from polyether polyols can be less susceptible to hydrolysis upon outdoor exposure and can provide better weathering performance than urethanes derived from polyester polyols.

Where HO-B-OH is a hydroxyl-capped prepolymer, a wide variety of precursor molecules can be used to produce the desired HO-B-OH prepolymer. For example, the reaction of polyols with less than stoichiometric amounts of diisocyanates can produce a hydroxyl-capped polyurethane prepolymer. Examples of suitable diisocyanates include, for example, aromatic diisocyanates, such as 2,6-toluene diisocyanate, 2, 5-toluene diisocyanate, 2, 4-toluene diisocyanate, m-phenylene diisocyanate, p-phenylene diisocyanate, methylene bis(o-chlorophenyl diisocyanate), methylenediphenylene-4,4'- diisocyanate, methylenediphenylene-2,4'- diisocyanate, polycarbodiimide-modified methylenediphenylene diisocyanate, (4,4'-diisocyanato-3,3',5, 5'-tetraethyl) biphenylmethane, 4,4'-diisocyanato-3,3'- dimethoxybiphenyl, 5-chloro-2,4-toluene diisocyanate, 1-chloromethyl-2,4-diisocyanato benzene, aromatic-aliphatic diisocyanates such as m-xylylene diisocyanate, tetramethyl-m-xylylene diisocyanate, aliphatic diisocyanates, such as 1,4-diisocyanatobutane, 1,6-diisocyanatohexane, 1, 12-diisocyanatododecane, 2-methyl- 1,5 diisocyanatopentane, and cycloaliphatic diisocyanates such as methylene-dicyclohexylene-4,4'-diisocyanate, and 3-isocyanatomethyl-3,5,5-trimethylcyclohexyl isocyanate (isophorone diisocyanate). For reasons of weatherability, generally aliphatic and cycloaliphatic diisocyanates are used.

In the production of thermoplastic polyurethanes, a chain extender may be used. Chain extenders can include diamines or short-chain diols. Preferred chain extenders are diols such as 1,4-butanediol, 1,3-butanediol, ethylene glycol, diethylene glycol, propylene glycol, pentanediol, 3-methylpentane-1,5-diol, hexanediol, hydroquinone bis(2-hydroxyethyl)ether (HQEE), 1,4-cyclohexanedimethanol (CHDM), or hydrogenated bisphenol A (HBPA).

Small amounts of polyols with more than two hydroxyl groups per molecule can lead to branching of a thermoplastic polyurethane. Larger amounts of polyols with more than two hydroxyl groups per molecule can lead to a crosslinked resin upon reaction with di or higher functionality isocyanates. Crosslinking can prevent creep of the formed polymer and can be tuned to maintain the desired mechanical properties.

While the relative amounts of long-chain and short-chain polyol can vary over a wide range depending on the hardness desired, the overall relative amounts of polyisocyanate to polyol are generally selected to be nearly stoichiometric equivalent amounts. In some instances, it may be desired to use an excess of one component, such as polyol, to minimize unreacted remnant of the other component. In some instances, it may be desired to use an excess of polyisocyanate.

The kinetics of the polymerization between the polyisocyanate and polyol species is typically accelerated with the help of a suitable catalyst, including dibutyltin dilaurate, dibutyltin diacetate, stannous octoate, triethylene diamine, zirconium catalysts, zinc catalysts and bismuth catalysts.

The hardness of the polyurethane is controlled by the relative amounts of hard segment and soft segment. The

hard segment content is calculated from the relative weights of starting materials used in preparing the thermoplastic polyurethane. In the embodiments described herein, the hard segment content is determined using the following formula:

$$Hard\ Segment\ (\%) = \frac{[\,wt.\,of\ the\ short\ chain\ polyol + wt.\,of\ the\ polyisocyanate\,]}{Total\ weight\ of\ [polyol(s) + \ Isocyanate + \ additives} \ x\ 100\%$$

The thermoplastic polyurethane has a hard segment content of at least 55%, or at least 60%. In some instances, the thermoplastic polyurethane has a hard segment content of at most 80% or at most 75%, or at most 70%, or at most 65%, or at most 60%, or at most 55% relative to the overall weight of the thermoplastic polyurethane. In some embodiments, the thermoplastic polyurethane has a hard segment content between 60% and 80%, preferably between 65% and 75%.

The properties of the polyurethane outer protective layer can be selected to provide optimal adhesion, abrasion resistance, and chemical resistance. In some embodiments, the polyurethane has a hardness of at least 90 Shore A, at least 40 Shore D, at least 50 Shore D, or at least 60 Shore D. In some embodiments, the polyurethane has a hardness of no more than 80 Shore D, or no more than 70 Shore D, or no more than 60 Shore D, or no more than 50 Shore D. In some embodiments, the polyurethane has a glass transition temperature (as measured by dynamic mechanical analysis) of at least 0°C, at least 10°C, at least 20°C, or at least 30°C. In some embodiments, the polyurethane has a glass transition temperature of no more than 30°C, no more than 20°C, or no more than 10°C. In some embodiments, the polyurethane has a storage modulus at 25°C (as measured by dynamic mechanical analysis) of at least 3 MPa, at least 5 MPa, at least 10 MPa, at least 20 MPa, or at least 35 MPa. In some embodiments, the polyurethane has a storage modulus of no more than 100 MPa, no more than 50 MPa, no more than 35 MPa, or no more than 20 MPa. In some embodiments, the polyurethane has an elongation to failure of at least 100%, at least 150%, at least 200%, or at least 250%. In some embodiments, the polyurethane has a tensile strength of at least 30 MPa, at least 40 MPa, or at least 50 MPa. The tensile properties can be measured by a suitable test method such as that described in ASTM D 412 - Standard Test Methods for Vulcanized Rubber and Thermoplastic Elastomers.

In some embodiments, the polyurethane outer protective film layer can be an aliphatic thermoplastic polyurethane layer formed using conventional techniques known to those of ordinary skill in the art. Such techniques include, for example, coating or extruding onto a substrate. One skilled in the art can coat or extrude the disclosed polyurethane compositions onto a substrate, such as of the barrier film using either batch or continuous techniques.

In a preferred method, an aliphatic thermoplastic polyurethane is formed by extruding it at an elevated temperature through an extrusion die. The thermoplastic polyurethane layer may also be formed by casting or otherwise molding (for example, injection molding) the thermoplastic polyurethane into the shape desired.

In some embodiments, the polyurethane outer protective film layer can be a thermoset polyurethane. The thermoset polyurethane can be formed by coating a mixture of polyisocyanate and polyol onto a substrate and allowing the polyurethane to polymerize in situ. In some embodiments, the polyol can have a functionality greater than 2 to contribute to significant crosslinking of the thermoset polyurethane. In some embodiments, the polyisocyanate can have a functionality greater than 2 to contribute to significant crosslinking of the thermoset polyurethane.

In some embodiments, a polyurethane can be dissolved in a solvent, and the polyurethane solution can be coated onto a substrate. The solvent can then be evaporated to leave a polyurethane outer protective film layer.

While aliphatic polyurethanes show good stability to ultraviolet weathering, the addition of UV stabilizers can further improve their stability and the stability of the materials disposed beneath the polyurethane outer protective film of the exemplary barrier assembly described herein when exposed to the environment. Examples of suitable UV stabilizers include ultraviolet absorbers (UVAs), Hindered Amine Light Stabilizers (HALS), and antioxidants. It has been found useful to choose additives that are soluble in the reactive mixture, especially in the polyol. Benzotriazole UVAs such as the compounds TINUVIN P, 213, 234, 326, 327, 328, 571 and 928 available from Ciba, Tarrytown, NY; triazines compounds such as TINUVIN 400, 405, 977 and 1700 available from Ciba, Tarrytown, NY; HALS such as TINUVIN 123, 144, 622, 765, 770 available from Ciba, Tarrytown, NY; and the antioxidants IRGANOX 1010, 1135 and 1076 available from Ciba, Tarrytown, NY, are particularly useful. The material TINUVIN B75, a product containing UVA, HALS and antioxidant available from Ciba, Tarrytown, NY is also suitable.

The reactive mixture forming the polyurethane layer may contain additional additives, if desired, as long as the additive does not interfere with the urethane polymerization reaction or adversely affect the properties of the formed polyurethane layer. Additives may be added to aid the mixing, processing, or coating of the reactive mixture or to aid the final properties of the formed polyurethane layer. Examples of additives may include particulate fillers, including nanoparticles or larger particles; mold release agents; low surface energy agents; antimildew agents; antifungal agents; antifoaming agents; antistatic agents; and coupling agents such as amino silanes and isocyanato silanes. Combinations of

additives can also be used.

While it is generally desirable for the polyurethane outer protective film layer to be transparent in solar applications in order to maximize efficiency of the solar cell, in certain cases a colorant additive may be added for aesthetic purposes to hide or camouflage certain aspects of the photovoltaic cell. Alternatively, the surface of the polyurethane outer protective film layer may be textured. For example, a matte texture may be applied to the surface of the polyurethane outer protective film layer to provide additional or useful camouflage capability. U.S. Patent Publication No. 2012/0199198 discloses how a structured surface finish can provide additional efficiency gains due to reduced surface reflection of a structured polyurethane surface layers.

Fig. 4 shows a second embodiment of an exemplary barrier assembly 200. Barrier assembly 200 is similar barrier assembly 100 shown in Fig. 3, except that the single-layer polyurethane outer protective film layer is replaced by a multilayer polyurethane outer protective film layer 230. Specifically, multilayer polyurethane outer protective film layer 230 comprises a first polyurethane layer 232 directly bonded to the surface of barrier film 220 and a second polyurethane layer 234 formed on the surface of the first polyurethane layer. Having a polyurethane outer protective film layer comprising a plurality of polyurethane layers permits the composition of the layers to be modified to optimize the properties of the polyurethane outer protective film layer. For example, the hard segment content of the first polyurethane layer may be less than the hard segment content of the second polyurethane layer resulting in a softer more compliant first polyurethane layer and a tougher more scratch resistant second polyurethane layer. The lower hard segment first polyurethane layer could be oriented toward the barrier surface to achieve increased adhesion and a higher hard segment polyurethane could be oriented toward the outside improving the hardness and durability of the surface of the solar device.

Alternatively, the first and second polyurethane layers may have different chemical compositions. For example, the first polyurethane layer may comprise a polyester polyol while the second polyurethane layer comprises a polyether polyol.

Fig. 5 is schematic cross-section of a bifacial solar cell assembly 350 comprising first and second exemplary barrier assemblies 100, 100' according to the present disclosure, wherein both the front and back surfaces 351, 352 of solar cell assembly 350 are exposed to light. Solar cell assembly 350 comprises an array photovoltaic cells (note: only a single photovoltaic cell 380 is illustrated in Fig. 5) disposed between the first and second exemplary barrier assemblies 100, 100'. Specifically, the front side 351 of solar cell assembly 350 is exposed to incoming light from the sun, $hv_I$, and the back side 352 of the solar cell assembly is exposed to reflected light, $hv_R$.

Solar cell assembly 350 may further comprise an encapsulant 375 at least partially surrounding the photovoltaic cell(s) 380. In the exemplary solar assembly shown in Fig. 5, the encapsulant 375 substantially surrounds the photovoltaic cell 380.

Barrier assembly 100 is disposed above the photovoltaic cell 380 and in direct contact with encapsulant 375. The barrier assembly comprises a barrier film 120 and a polyurethane outer protective film layer 130 bonded directly to exposed major surface of the barrier film. Polyurethane outer protective film layer 130 forms a front surface 351 of the solar cell assembly 350 that is exposed to incoming light, $hv_I$. The barrier assembly further comprises a polymeric film substrate 140 beneath the barrier film and in direct contact with the encapsulant 375.

Barrier assembly 100' is disposed below the photovoltaic cell 380 and in direct contact with encapsulant 375 beneath the photovoltaic cell. Barrier assembly 100', shown in Fig. 5, has the same general structure and barrier assembly 100 described above, except that it has been reoriented such that the a polyurethane outer protective film layer 130' forms a back surface 352 of the solar cell assembly 350 that is exposed to reflected light, $hv_R$ allowing the solar cell assembly to accept reflected light through the bottom surface of the assembly. The barrier assembly further comprises a polymeric film substrate 140' disposed on the opposite side of barrier film 120' to which the barrier film opposite polyurethane outer protective film layer 130, such that polymeric film substrate 140' is in direct contact with encapsulant 375 below the photovoltaic cell 380.

Fig. 6 is schematic cross section of a portion of a second solar cell assembly 450 comprising first and second exemplary barrier assemblies 100, 100' according to the present disclosure at both the front and back surfaces 451, 452 of solar cell assembly 450 are exposed to light. Solar cell assembly 450 comprises flexible thin film photovoltaic cells 480 disposed between the first and second exemplary barrier assemblies 100, 100'to improve the overall flexibility of the solar cell assembly, while also reducing the weight of the solar cell assembly. In some embodiments, the front side 451 of solar cell assembly 450 is exposed to incoming light from the sun, $hv_I$, and the back side 452 of the solar cell assembly is exposed to reflected light, $hv_R$, potentially improving the efficiency of the solar cell assembly.

Solar cell assembly 450 furthers comprise a first encapsulant layer 475 disposed between the thin film photovoltaic cells 480 and the first barrier film assembly 100 such that the polymeric film substrate 140 is in direct contact with the encapsulant 475 and the polyurethane outer protective film layer 130 forms the front surface 451 of the solar cell assembly 450, and a second encapsulant layer 476 disposed between the bottom of the thin film photovoltaic cells 480 and the second barrier film assembly 100', such that polymeric film substrate 140' is in direct contact with the second encapsulant layer 476 and the polyurethane outer protective film layer 130' forms the back surface 452 of the solar cell assembly 450.

Fig. 7 is schematic cross section of a portion of a third solar cell assembly 550 comprising an exemplary barrier assembly 100 according to the present disclosure. Barrier assembly 100 is arranged such that the polyurethane outer protective film layer 130 forms a top surface 551 of the solar cell assembly 550. In this embodiment the active portion of the solar cell comprises a thin film photovoltaic cell 580 made up of a plurality of solar cell layers. In an exemplary embodiment, the solar cell layers can be applied or formed in a prescribed order on a second major surface 142 of polymeric film substrate 140 of the exemplary barrier assembly.

The solar cell layers comprise one or more front transport or conductor layers 582 are disposed on the second major surface 142 of polymeric film substrate 140 of barrier assembly 100. One or more photoactive layers 584 are formed on the front transport layer(s). One or more rear transport or conductor layers 586 are formed on an exposed surface of photoactive layer 584. In one exemplary embodiment, the thin film photovoltaic cell 580 can be an OVP cell that comprises a thin metal or indium tin oxide (ITO) as the first conductor layer, a poly(3,4-ethylenedioxythiophene) photoactive layer and a second ITO layer as the second conductor layer. In an alternative embodiment, the thin film photovoltaic cell 580 can be a perovskite solar cell comprising an electron transport layer, a hybrid organic-inorganic lead or tin halide-based material as the photoactive layer and a hole transport layer. In another alternative, the thin film photovoltaic cell 580 can be a dye-sensitized solar cell comprising a first conductor layer, a porous titanium oxide layer, a dye layer, and an electrolyte layer as the photoactive layers, and a second conductor layer.

Solar cell assembly 550 can further comprise an encapsulant or adhesive layer 575 disposed beneath the thin film photovoltaic cell 580 that is configured to attach the thin film photovoltaic cell to a supporting substrate 560 such as a glass plate or conventional back sheet material.

Fig. 8 illustrates a fourth solar cell assembly 550' which is substantially the same as solar cell assembly 550 shown in Fig. 7, except that supporting substrate 560 has been replaced by a second barrier assembly 100'. The first barrier assembly (i.e. barrier assembly 100) comprises a barrier film 120 and a polyurethane outer protective film layer 130 bonded directly to exposed major surface of the barrier film. Polyurethane outer protective film layer 130 forms a front surface 551' of the solar cell assembly 550' that is exposed to incoming light, $hv_I$. The barrier assembly further comprises a polymeric film substrate 140 beneath the barrier film that is in direct contact with thin film photovoltaic cell 580'.

The second barrier assembly 100' is disposed below the thin film photovoltaic cell 580' and in direct contact with encapsulant 575' beneath the photovoltaic cell. Barrier assembly 100' has the same general structure and barrier assembly 100 described above, except that it has been reoriented such that polyurethane outer protective film layer 130' forms a back surface 552' of the solar cell assembly 550' that is exposed to reflected light, $hv_R$. The barrier assembly further comprises a polymeric film substrate 140' disposed on the opposite side of barrier film 120' from polyurethane outer protective film layer 130', such that polymeric film substrate 140' is in direct contact with encapsulant 575' below the photovoltaic cell 580'.

The barrier assemblies according to the present disclosure are useful, for example, for protecting photovoltaic/solar cells. In some embodiments, the assembly is disposed on, above, or around a photovoltaic cell. Accordingly, the present disclosure provides a method comprising applying an assembly disclosed herein to the front surface of a photovoltaic cell. Suitable solar cells include those that have been developed with a variety of materials each having a unique absorption spectrum that converts solar energy into electricity. Each type of semiconductor material will have a characteristic band gap energy which causes it to absorb light most efficiently at certain wavelengths of light, or more precisely, to absorb electromagnetic radiation over a portion of the solar spectrum.

Examples of materials used to make solar cells and their solar light absorption band-edge wavelengths include: crystalline silicon single junction (about 400 nm to about 1150 nm), amorphous silicon single junction (about 300 nm to about 720 nm), ribbon silicon (about 350 nm to about 1150 nm), CIS (Copper Indium Selenide) (about 400 nm to about 1300 nm), CIGS (Copper Indium Gallium di-Selenide) (about 350 nm to about 1100 nm), CdTe (about 400 nm to about 895 nm), GaAs multi-junction (about 350 nm to about 1750 nm). The shorter wavelength left absorption band edge of these semiconductor materials is typically between 300 nm and 400 nm. One skilled in the art understands that new materials are being developed for more efficient solar cells having their own unique longer wavelength absorption band-edge and the multilayer reflective film would have a corresponding reflective band-edge. In some embodiments, the assembly disclosed herein is disposed on, above, or around a CIGS cell. In some embodiments of barrier assemblies according to the present disclosure, the solar device (e.g., the photovoltaic cell) to which the assembly is applied comprises a flexible film substrate.

In some exemplary embodiments, one of the top or bottom surfaces of the solar cell assembly can be optionally coated with an antireflective (AR) coating, an anti-soiling coating, or a scratch resistant coating. In particular, the coatings may be applied to the exposed surface of the polyurethane outer protective layer to further enhance the protective properties of the layer.

Barrier assemblies may also be useful, for example, for displays such as electrophoretic, electrochromic, and OLED displays.

## EXAMPLES

Unless otherwise noted or readily apparent from the context, all parts, percentages, ratios, etc. in the Examples and the rest of the specification are by weight.

### 180 Degree Peel Test Method

Peel testing was done in accordance with ASTM D3330 180 degree peel test description. Test specimens were cut to 0.5 inch wide strips from the Mock solar cell samples after aging for the specified time in an environmental chamber at 85°C and 85% relative humidity. Peel adhesion testing was done at room temperature in an environmentally controlled room. The peel testing was done using an IMASS SP-2000 Peel Tester available from IMASS, Inc. (Accord, MA, USA) at 90 inch/min, with a 5 kg load cell, 5 sec averaging, 1 sec delay. The samples were affixed to the moving tray such that the polyurethane was on top and peeled off the barrier film. Measurements were taken for 2 or 3 strips and the average peel force is reported.

### Materials Used in the Preparation of the Polyurethane Materials

| Abbreviation | Description and Source |
|---|---|
| PBAP | Fomrez® 44-111 polyester polyol (Poly(butylene adipate) polyol with a hydroxy number of 111) obtained from Lanxess (Cologne, Germany). |
| PTMEG | TERATHANE 1000 Polyether Glycol (polytetramethylene ether glycol - CAS No. 25190-06-1, with a hydroxyl number of 111) obtained from The Lycra Company )Wilmington, DE, USA). |
| 1,4-BDO (Chain Extender) | 1,4-butanediol, obtained from BASF Corporation (Ludwigshafen, Germany). |
| DBTDL | FASCAT 4202 catalyst, dibutyltin dilaurate (CAS No. 77-58-7), obtained from PMC Organometallix, Inc. (Mount Laurel, NJ, USA). |
| H12MDI | DESMODUR W diisocyanate, (Hydrogenated methylene diphenyl isocyanate having a Mw of 262, functionality of 2 and Eq of 131) obtained from Covestro AG (Leverkusen, Germany). |
| Benzotriazole | TINUVIN 571 Benzotriazole Ultraviolet Absorber (UVA), ( 2-(2H-Benzotriazol-2-yl)-6-dodecyl-4-methylphenol - CAS No. 23328-53-2) obtained from BASF Corporation (Ludwigshafen, Germany). |
| HALS | TINUVIN 292 Liquid Hindered Amine Light Stabilizer (a mixture of bis(1,2,2,6,6-pentamethyl-4-piperidyl)sebacate - CAS No. 41556-26-7 and Methyl 1,2,2,6,6-pentamethyl-4-piperidyl sebacate - CAS No. 82919-37-7) obtained from BASF Corporation, (Ludwigshafen, Germany). |
| Phenolic Stabilizer | IRGANOX 1076 Phenolic Antioxidant Stabilizer, (octadecyl-3-[3,5-di-tert-butyl-4-hydroxyphenyl]propionate] - CAS No. 2082-79-3), obtained from BASF Corporation, (Ludwigshafen, Germany). |

### Additional Materials Used to create Exemplary Barrier Assemblies

| Abbreviation | Description and Source |
|---|---|
| JURASOL | JURASOL® TL Solar Encapsulation Sheet available from Jura-plast GmbH (Reichenschwand, Germany). |
| ETFE | Ethylene-tetrafluoroethylene (ETFE) film with surface treatment (C-treatment) available under the trade name "NOR-TON® ETFE" from St Gobain Performance Plastics, (Wayne, NJ, USA). |
| FTB3-50 | 3M™ Flexible Transparent Barrier (FTB3-50) Film (3M™ FTB Film 3-50 for General Use) available from 3M Company (St. Paul, MN, USA). Thickness 50 $\mu$m |

(continued)

| Abbreviation | Description and Source |
|---|---|
| UBF 5 | 3M™ Ultra Barrier Film (UBF) available from 3M Company (St. Paul, MN, USA). Thickness 125 μm |
| UBF 512 | 3M™ Ultra Barrier Film (UBF) available from 3M Company (St. Paul, MN, USA). Thickness 200 μm |

Preparation of Polyurethane Materials

The polyurethanes were produced in a reactive urethane extruder (Omega 20, co-rotating twins screw extruder from Steerworld, Bangalore India with screw diameter 20 mm), as generally described in Example 1 of U.S. Patent No. 8,128,779, the disclosure of which is incorporated herein by reference in its entirety. Polyols and catalyst are added in the first and second barrel zone. Isocyanate is added in the third barrel zone. UV stabilizers are added in the fourth barrel zone. There are mixing elements after each add to mix the components. The resulting polyurethane was extruded onto a release liner to make a polyurethane film which could be laminated to the second polymer layer of an exemplary barrier film to yield a barrier assembly or was extruded directly onto the second polymer layer of a barrier film to form an exemplary barrier assembly. The target thickness for the polyurethane film layers was optimized to be approximately 50um thickness. Exemplary polyurethane compositions are shown in Table 1.

Table 1. Exemplary Compositions for the Polyurethane Outer Protective Film Layer

| | PU-A | PU-B | PU-C | PU-D | PU-E |
|---|---|---|---|---|---|
| PBAP (ester) | | | 36.7% | | |
| PTMEG (ether) | 43.4% | 36.7% | | 36.7% | 29.0% |
| 1,4-BDO | 10.8% | 13.0% | 13.0% | 12.4% | 15.5% |
| DBTDL | 0.04% | 0.04% | 0.04% | 0.04% | 0.03% |
| Benzotriazole | 1.4% | 1.4% | 1.4% | 1.4% | 1.5% |
| HALS | 1.0% | 1.0% | 1.0% | 1.0% | 1.0% |
| Phenolic stabilizer | 1.1% | 1.0% | 1.0% | 1.0% | 0.8% |
| H12MDI | 42.3% | 46.9% | 46.9% | 47.5% | 52.3% |
| Hard Segment | 55% | 62% | 62% | 62% | 70% |
| Isocyanate Index | 0.99 | 0.99 | 0.99 | 1.04 | 0.99 |

Method I: Creating a Barrier Assembly via a Lamination Process

Extruded polyurethane films are attached to the barrier surface via hot lamination in a vacuum laminator. In these examples, no pressure sensitive adhesive is used. Samples are prepared by placing a 12 inch x 36 inch sheet of polyurethane film on the barrier surface of similarly sized sheet of UBF 5 with protective liner removed from barrier surface. The two films are then placed between large polytetrafluoroethylene sheets inside the lamination table. The lamination table is a Spire 350 Vacuum Laminator (commercially available from Spire Corporation Bedford, Mass.). The assembly was cured for 15 minutes at 160°C under 1 atm ($1 \times 10^5$ Pa) pressure. This method ensured the urethane is fully cured on the underlying barrier stack. The resulting film is polyurethane covered barrier assembly. Exemplary barrier assembly constructions are summarized in Table 2.

Method II: Creating a Barrier Assembly via a Direct Coating Process

Extruded polyurethane films are attached to the barrier film by extruding the polyurethane directly onto the barrier film surface. In these examples, no pressure sensitive adhesive is used. During preparation of urethanes an 8 inch x 15 inch sheet of barrier film with the protective liner removed is placed on the extrusion liner where the polyurethane is extruded onto. When removed from the extrusion liner, the resulting film is a polyurethane covered barrier assembly. Exemplary barrier assembly constructions are summarized in Table 2.

Fabrication of a Mock Solar Cell Assembly

Mock Solar Assemblies for testing inside environmental chambers were made by laying a sheet of JURASOL® TL encapsulant between two sheets of polyurethane coated barrier assemblies such that the polyurethanes faced outward on both sides. The 3-layer stack of materials was then placed between large polytetrafluoroethylene sheets on the lamination table of a Spire 350 Vacuum Laminator (commercially available from Spire Corporation Bedford, Mass.). The laminate was cured for 10 minutes at 120°C under 1 atm (1x105 Pa) pressure. The resulting panel is representative of a solar module without having any solar cells or wiring and can be used for environmental testing of the covering materials.

Table 2. Exemplary Barrier Assemblies

| | | | | | Peel Adhesion of Mock Solar Cell Samples | | | |
|---|---|---|---|---|---|---|---|---|
| Example | Protective Layer | Hard Segment | Barrier Material | Assembly Method | 0 hrs. | 250 hrs. | 500 hrs. | 1000 hrs. |
| Ex. 1 | PU-A | 55 | UBF 5 | II | 144 | 437 | 423 | NT |
| Ex. 2 | PU-B | 62 | FTB3-50 | I | 915 | 251 | 245 | 21 |
| Ex. 3 | PU-B | 62 | FTB3-50 | II | 134 | 330 | 66 | NT |
| Ex. 4 | PU-B | 62 | UBF 5 | I | 825 | 235 | 332 | 336 |
| Ex. 5 | PU-B | 62 | UBF 5 | II | 26 | 322 | 299 | NT |
| Ex. 6 | PU-C | 62 | FTB3-50 | II | 225 | 0 | 0 | NT |
| Ex. 7 | PU-D | 62 | UBF 5 | II | 399 | 326 | 436 | NT |
| Ex. 8 | PU-E | 70 | UBF 5 | II | 11 | 159 | 111 | NT |
| CE 1 | ETFE | N/A | FTB3-50 | I | 5 | 6 | 0 | 0 |
| UBF512 | ETFE | N/A | UBF 5 | NA | 465 | NT | NT | NT |

UBF 512 is a commercially available barrier film (manufactured by 3M Company, St. Paul MN) having a 25 micron ETFE cover layer adhered to the surface of the second polymer layer of the barrier film using a pressure sensitive adhesive.

CE 1 is a sample having a 50 micron ETFE cover layer laminated directly to the second polymer layer of a barrier film using assembly Method I.

Comparing Example Ex. 2 to CE 1 illustrates the improved adhesion of a polyurethane outer protective layer compared to an ETFE polyurethane outer protective layer, which is a conventional material used as an outer protective layer, when the outer protective layer is laminated directly to the surface of the second polymer layer of the barrier film.

Comparing Example Ex. 2 to Ex. 4 shows improved adhesion in a barrier assembly having a urethane based coupling agent in the second polymer layer of the barrier film over time (e.g., at 1000 hours) when exposed to accelerated aging at 85°C and 85% relative humidity.

Comparing Example Ex. 1, Ex. 5 and Ex. 8 illustrates the effect of hard segment content in an ether-based polyurethane outer protective layer. Ex. 1 with the lower hard segment content shows higher adhesion than the samples with higher hard segment content. Each of the samples show improved adhesion values over time during aging.

Comparing Example Ex.5 to Ex. 7 shows that the addition of a slight excess of isocyanate in the ether-based polyurethane outer protective layer can significantly improve initial adhesion, possibly due to the formation of covalent bonds between the urethane based coupling agent in the second polymer layer of the barrier film and the polyurethane outer protective layer.

Example Ex. 6 illustrates that an ester based polyurethane outer protective layer can have initial higher adhesion than the ether based polyurethane outer protective layer of example Ex. 3, but this improvement degrades over time when exposed to accelerated aging at 85°C and 85% relative humidity.

Scratch Hardness Test

A scratch hardness test was performed on the surface of samples, following ASTM 3363-20. 8.1.1.2 Scratch hardness results were obtained by holding pencils at 45° and pushing forward for 6 mm. Continuing from hardest to softest, it was determined whether a pencil will scratch or rupture the film sample. UNI pencils were used and were made by

Mitsubishi Pencil (Japan). All of the pencil levels are reported below in the following Diagram 1.

Diagram 1

6B – 5B – 4B – 3B – 2B – B – HB – F – H – 2H – 3H – 4H – 5H – 6H

Softer Harder

Table 3 = Scratch Test Results

| Example | Polyurethane | Scratch Hardness |
|---|---|---|
| Ex. 1 | PU-A | 2B |
| Ex. 2 | PU-B | H |
| Ex. 3 | PU-B | H |
| Ex. 4 | PU-B | H |
| Ex. 5 | PU-B | H |
| Ex. 6 | PU-C | 3B |
| Ex. 7 | PU-D | F |
| Ex. 8 | PU-E | 2H |
| CE 1 | ETFE | <6B |
| UBF512 | ETFE | <6B |

The urethane examples herein all outperformed CE1 and UBF512 for scratch hardness, in particular Ex 8.

Overall, Tables 2 and 3 show that using a urethane protective layer in the barrier film construction examples and embodiments herein can provide benefits in properties such as peel adhesion strength and scratch resistance, depending on the particular application.

Transmission Tests

Transmission measurements were performed with a LAMBDA 1050+ UV/Vis/NIR Spectrophotometer with a 150 mm integrating sphere accessory, from PerkinElmer (Waltham, MA). Samples were placed in the machine and measured transmission from 300 to 2500 in 5nm increments. The solar direct transmission was calculated per ISO 9050 - "Glass in Building - Determination of Light Transmittance, Solar Direct Transmittance, Total Solar Energy Transmittance, Ultraviolet Transmittance and Related Glazing Factors".

It was observed that urethane coated film embodiments according to the invention provide visible/IR transmission characteristics greater than 90%, which is similar to the visible/IR transmission characteristics of ETFE covered films (within 0.5%), when measured in accordance with ISO9050.

**Claims**

**1.** A solar cell assembly (50) comprising:

a photovoltaic cell (80)
a supporting substrate (60) forming a bottom surface (52) of the solar cell assembly disposed beneath the photovoltaic cell (80); and
a barrier assembly (100) **characterized in that** it comprises a barrier film (120) and a polyurethane outer protective film layer (130) bonded directly to an exposed major surface of the barrier film (120), wherein the barrier assembly (100) disposed above the photovoltaic cell a (80) and the polyurethane outer protective film layer (130) forms a top surface (51) of the solar cell assembly (50) that is exposed to incoming light, and wherein the

polyurethane of the outer protective film layer (130) has a hard segment content equal to or greater than 55 % relative to the overall weight of the polyurethane.

2. The assembly of claim 1, wherein the barrier film (120) consists of an inorganic oxide layer disposed between first and second polymer layers (122, 124), wherein the first and second polymer layer (122, 124) each comprise a polymeric reaction product of at least one of acrylic or methacrylic monomers.

3. The assembly of either of claims 1 or 2, wherein the barrier assembly (100) further comprises a polymeric film substrate (140) having first and second major surfaces; wherein the barrier film (120) is disposed on the first major surface of the first polymeric film substrate (140).

4. The assembly of claim 3, wherein the second major surface of the polymeric film substrate (140) contacts an encapsulant that at least partially surrounds the photovoltaic cell (80), and wherein the second major surface of the polymeric film substrate (140) is directly bonded to the encapsulant disposed between the barrier assembly and the photovoltaic cell.

5. The assembly of any of the preceding claims, wherein the top surface of the solar assembly comprises one of an AR coating, an anti-soiling coating, or a scratch resistant coating.

6. The assembly of any of the preceding claims, wherein the supporting substrate (60) is a second barrier assembly forming a bottom surface (52) of the solar cell assembly wherein the barrier assembly (100) comprises a polyurethane outer protective film layer (130) forms the bottom surface (52) of the solar cell assembly.

7. The assembly of claim 6, wherein the solar cell assembly (100) is configured to accept light through the bottom surface (52) of the solar cell assembly (50)

8. The assembly of any of the preceding claims, wherein the photovoltaic cell (80) is an Organic photovoltaic (OPV) cell, a perovskite solar cell or a dye-sensitized solar cell.

9. The assembly of any of the preceding claims, wherein the polyurethane outer protective film layer (130) comprises one of an aliphatic polyurethane, an ester-based polyurethane, an. ether-based polyurethane or a polycarbonate-based polyurethane.

10. The assembly of any of the preceding claims, wherein the polyurethane protective film layer (130) further comprises at least one of an ultraviolet light stabilizer, a hindered amine light stabilizer, an antioxidant, and a thermal stabilizer.

## Patentansprüche

1. Eine Solarzellenanordnung (50), aufweisend:

eine Photovoltaikzelle (80)
ein Trägersubstrat (60), das eine untere Oberfläche (52) der Solarzellenanordnung ausbildet, das unterhalb der Photovoltaikzelle (80) eingerichtet ist; und
eine Sperrschichtanordnung (100), **dadurch gekennzeichnet, dass** es eine Sperrschichtfolie (120) und eine äußere Polyurethan-Schutzfolienschicht (130) aufweist, die an eine freiliegende Hauptoberfläche der Sperrschichtfolie (120) direkt gebunden ist, wobei die Sperrschichtanordnung (100), die über der Photovoltaikzelle (80) eingerichtet ist, und die äußere Polyurethan-Schutzfolienschicht (130) eine obere Oberfläche (51) der Solarzellenanordnung (50) ausbildet, die einfallendem Licht ausgesetzt ist, und wobei die äußere Polyurethan-Schutzfolienschicht (130) einen Hartsegmentgehalt gleich oder größer als 55 % bezogen auf das Gesamtgewicht des Polyurethans hat.

2. Die Anordnung nach Anspruch 1, wobei die Sperrschichtfolie (120) aus einer anorganischen Oxidschicht besteht, die zwischen der ersten und der zweiten Polymerschicht (122, 124) eingerichtet ist, wobei die erste und die zweite Polymerschicht (122, 124) jeweils ein polymeres Reaktionsprodukt aus mindestens einem von Acryl- oder Methacrylmonomeren aufweist.

3. Die Anordnung nach Anspruch 1 oder 2, wobei die Sperrschichtanordnung (100) ferner ein Polymerfoliensubstrat

(140), das erste und zweite Hauptoberflächen hat, aufweist; wobei die Sperrschichtfolie (120) auf der ersten Hauptoberfläche des ersten Polymerfoliensubstrats (140) eingerichtet ist.

4. Die Anordnung nach Anspruch 3, wobei die zweite Hauptoberfläche des Polymerfoliensubstrats (140) mit einem Verkapselungsstoff in Kontakt steht, der die Photovoltaikzelle (80) mindestens teilweise umgibt, und wobei die zweite Hauptoberfläche des Polymerfoliensubstrats (140) an dem Verkapselungsstoff, der zwischen der Sperrschichtanordnung und der Photovoltaikzelle eingerichtet ist, direkt gebunden ist.

5. Die Anordnung nach einem der vorstehenden Ansprüche, wobei die obere Oberfläche der Solaranordnung eine von einer AR-Beschichtung, einer schmutzabweisenden Beschichtung oder einer kratzfesten Beschichtung aufweist.

6. Die Anordnung nach einem der vorstehenden Ansprüche, wobei das Trägersubstrat (60) eine zweite Sperrschichtanordnung ist, die eine untere Oberfläche (52) der Solarzellenanordnung ausbildet, wobei die Sperrschichtanordnung (100) eine äußere Polyurethan-Schutzfolienschicht (130) aufweist, die eine untere Oberfläche (52) der Solarzellenanordnung ausbildet.

7. Die Anordnung nach Anspruch 6, wobei die Solarzellenanordnung (100) konfiguriert ist, um Licht durch die untere Oberfläche (52) der Solarzellenanordnung (50) zu akzeptieren.

8. Die Anordnung nach einem der vorstehenden Ansprüche, wobei die Photovoltaikzelle (80) eine organische Photovoltaikzelle (OPV), eine Perowskit-Solarzelle oder eine Farbstoffsolarzelle ist.

9. Die Anordnung nach einem der vorstehenden Ansprüche, wobei die äußere Polyurethan-Schutzfolienschicht (130) eines von einem aliphatischen Polyurethan, einem Polyurethan auf Esterbasis, einem Polyurethan auf Etherbasis oder einem Polyurethan auf Polycarbonatbasis aufweist.

10. Die Anordnung nach einem der vorstehenden Ansprüche, wobei die Polyurethan-Schutzfolienschicht (130) ferner mindestens einen von einem UV-Lichtstabilisator, einem Lichtstabilisator aus gehindertem Amin, einem Antioxidationsmittel und einem Wärmestabilisator aufweist.

## Revendications

1. Ensemble cellule solaire (50) comprenant :

   une cellule photovoltaïque (80) ;
   un substrat de support (60) formant une surface inférieure (52) de l'ensemble cellule solaire disposé sous la cellule photovoltaïque (80) ; et
   un ensemble barrière (100) **caractérisé en ce qu'il** comprend un film barrière (120) et une couche de film de protection extérieure (130) en polyuréthane collée directement sur une surface principale exposée du film barrière (120), dans lequel l'ensemble barrière (100) est disposé au-dessus de la cellule photovoltaïque (80) et la couche de film de protection extérieure (130) en polyuréthane forme une surface supérieure (51) de l'ensemble cellule solaire (50) qui est exposée à la lumière entrante, et dans lequel le polyuréthane de la couche de film de protection extérieure (130) présente une teneur en segments durs égale ou supérieure à 55 % par rapport au poids total du polyuréthane.

2. Ensemble selon la revendication 1, dans lequel le film barrière (120) est constitué d'une couche d'oxyde inorganique disposée entre la première et la seconde couche polymère (122, 124), dans lequel la première et la seconde couche polymère (122, 124) comprennent chacune un produit de réaction polymère d'au moins l'un parmi un monomère acrylique et un monomère méthacrylique.

3. Ensemble selon l'une ou l'autre des revendications 1 ou 2, dans lequel l'ensemble barrière (100) comprend en outre un substrat de film polymère (140) présentant une première et une seconde surface principale ; dans lequel le film barrière (120) est disposé sur la première surface principale du premier substrat de film polymère (140).

4. Ensemble selon la revendication 3, dans lequel la seconde surface principale du substrat de film polymère (140) entre en contact avec un agent d'encapsulation qui entoure au moins partiellement la cellule photovoltaïque (80), et dans lequel la seconde surface principale du substrat de film polymère (140) est directement collée à l'agent d'encapsulation disposé entre l'ensemble barrière et la cellule photovoltaïque.

5. Ensemble selon l'une quelconque des revendications précédentes, dans lequel la surface supérieure de l'ensemble solaire comprend l'un parmi un revêtement AR, un revêtement antisalissures ou un revêtement résistant aux rayures.

6. Ensemble selon l'une quelconque des revendications précédentes, dans lequel le substrat de support (60) est un second ensemble barrière formant une surface inférieure (52) de l'ensemble cellule solaire, dans lequel l'ensemble barrière (100) comprend une couche de film de protection extérieure (130) en polyuréthane qui forme la surface inférieure (52) de l'ensemble cellule solaire.

7. Ensemble selon la revendication 6, dans lequel l'ensemble cellule solaire (100) est configuré pour accepter la lumière à travers la surface inférieure (52) de l'ensemble cellule solaire (50).

8. Ensemble selon l'une quelconque des revendications précédentes, dans lequel la cellule photovoltaïque (80) est une cellule photovoltaïque organique (OPV), une cellule solaire à pérovskite ou une cellule solaire à colorant.

9. Ensemble selon l'une quelconque des revendications précédentes, dans lequel la couche de film de protection extérieure (130) en polyuréthane comprend l'un parmi un polyuréthane aliphatique, polyuréthane à base d'ester, polyuréthane à base d'éther ou polyuréthane à base de polycarbonate.

10. Ensemble selon l'une quelconque des revendications précédentes, dans lequel la couche de film de protection (130) en polyuréthane comprend en outre au moins l'un parmi un stabilisateur de lumière ultraviolette, un stabilisateur de lumière à amine encombrée, antioxydant et un stabilisateur thermique.

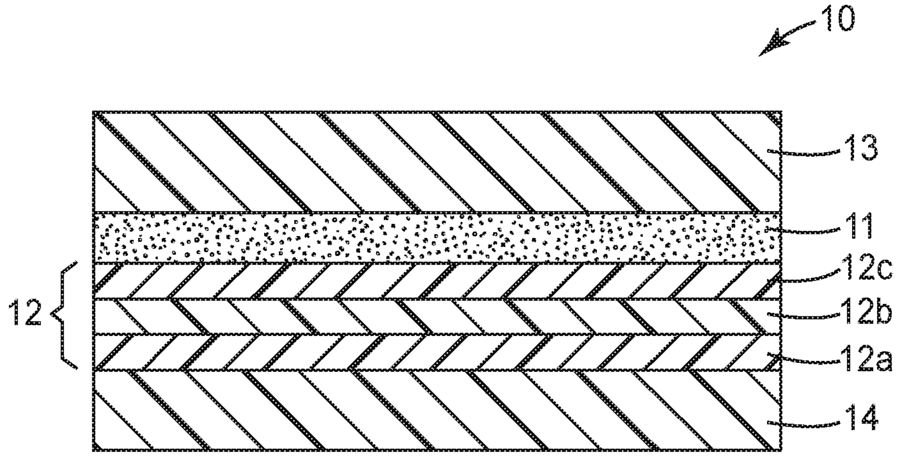


FIG. 1
Prior Art

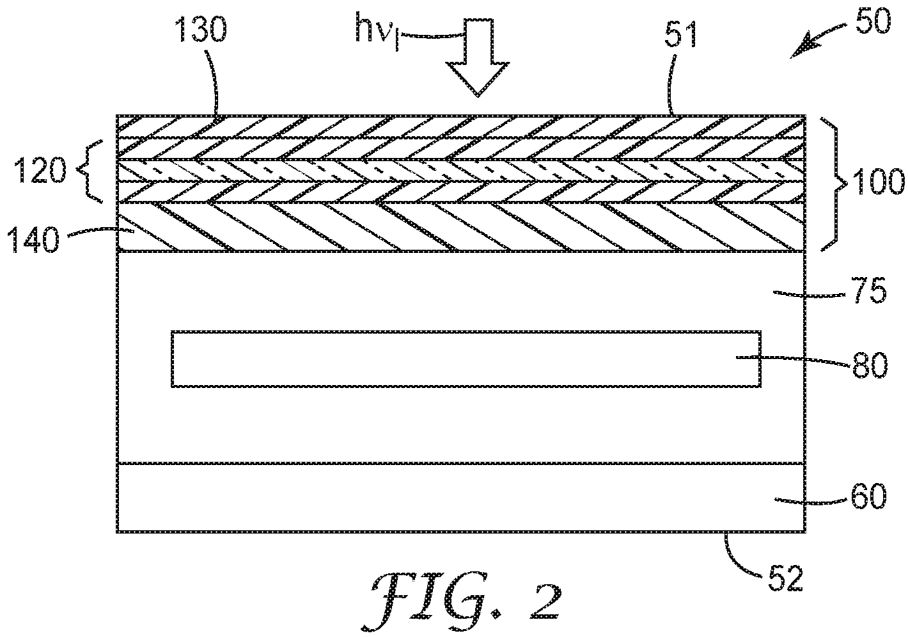


FIG. 2

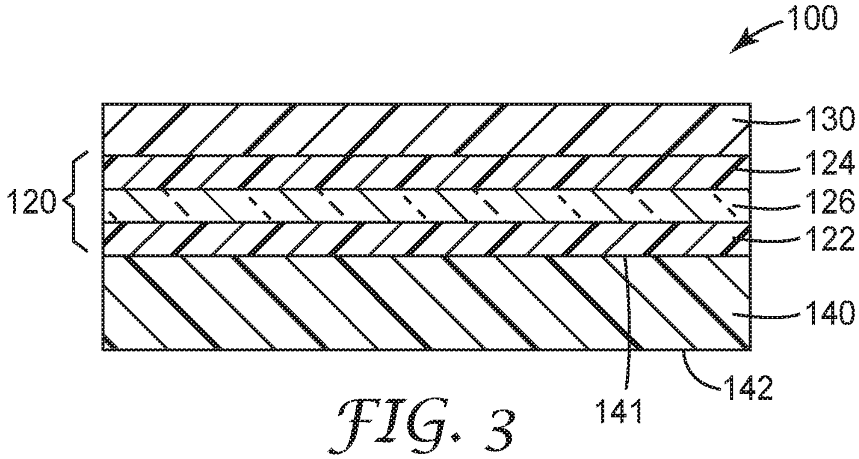


FIG. 3

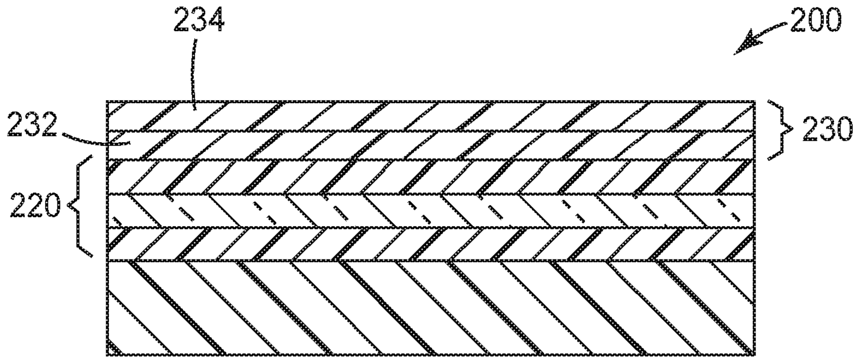


FIG. 4

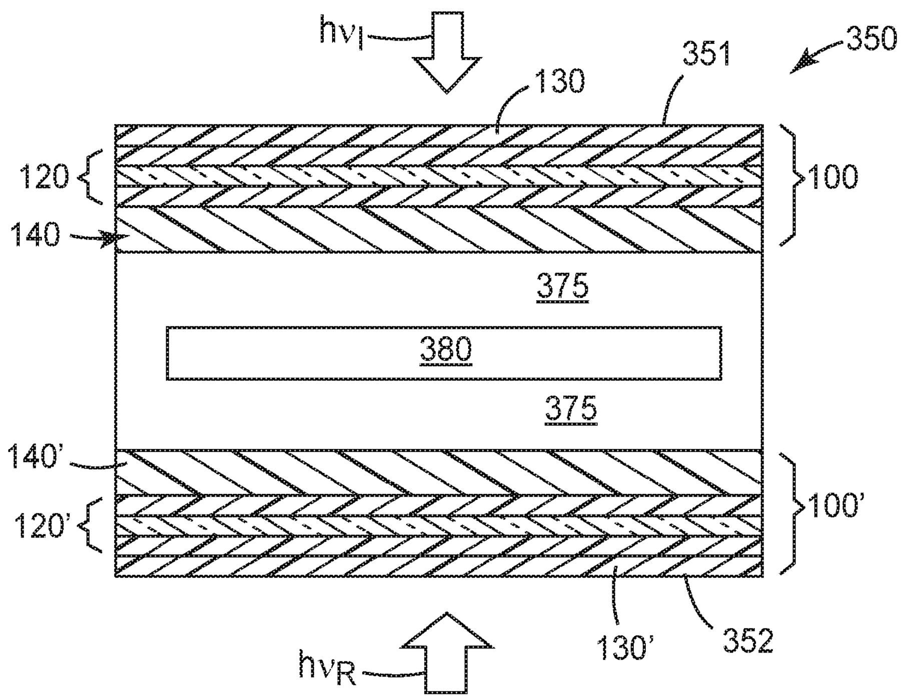


FIG. 5

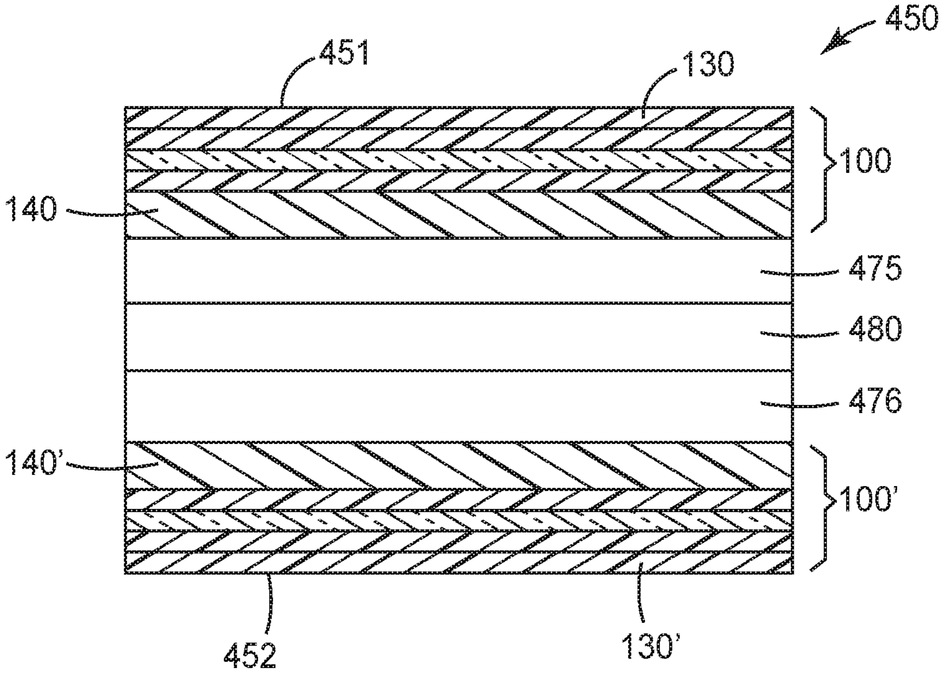
450
451
130
100
140
475
480
476
140'
100'
452
130'

FIG. 6

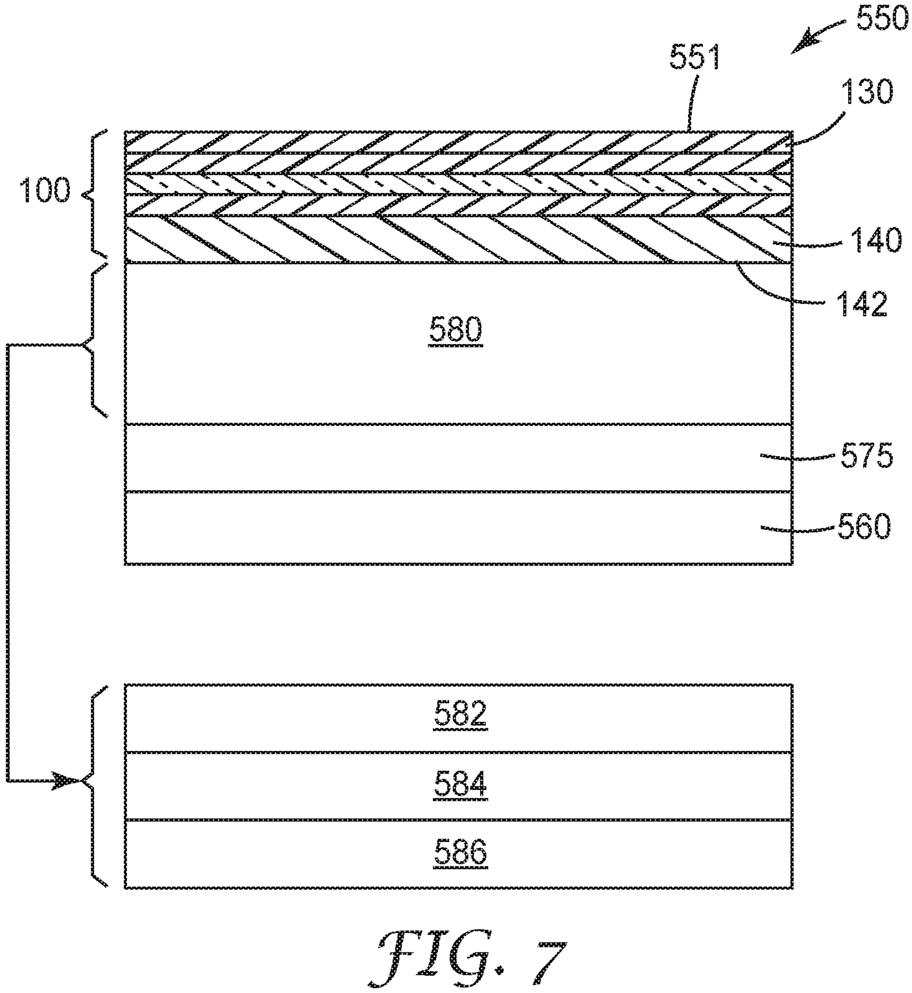
550
551
130
100
140
142
580
575
560
582
584
586

FIG. 7

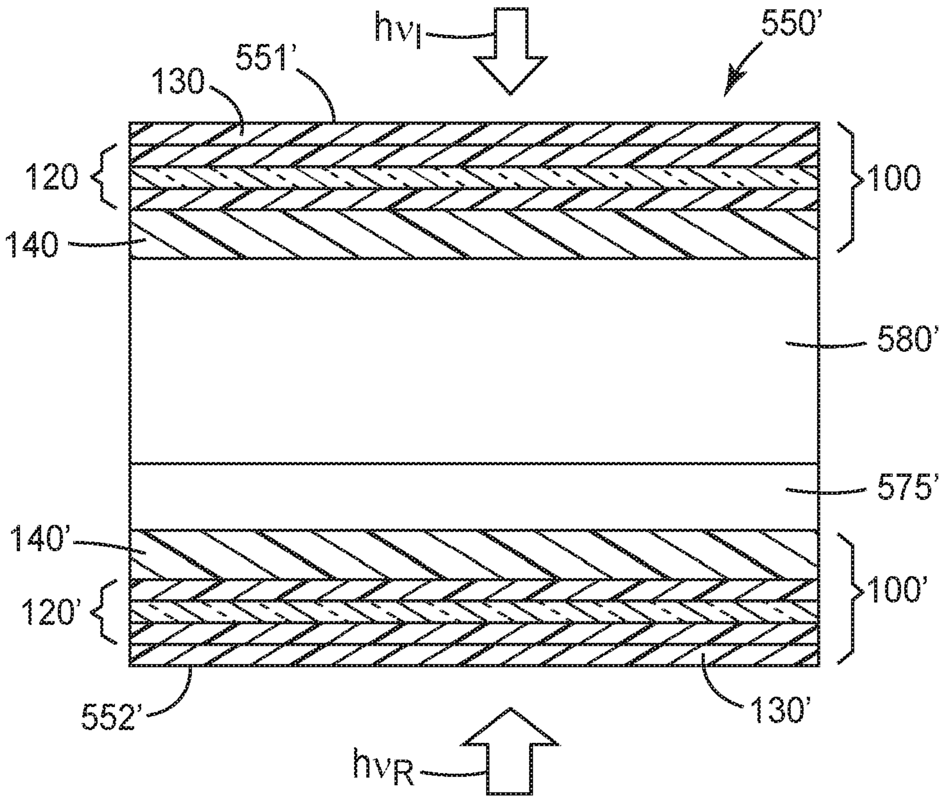


FIG. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 9997657 B
- US 20120003448 A1
- US 4696719 A, Bischoff
- US 4722515 A, (Ham)
- US 4842893 A, Yializis
- US 4954371 A, Yializis
- US 5018048 A, Shaw
- US 5032461 A, Shaw
- US 5097800 A, Shaw
- US 5125138 A, Shaw
- US 5440446 A, Shaw
- US 5547908 A, Furuzawa
- US 6045864 A, Lyons
- US 6231939 B, Shaw
- US 6214422 B, Yializis
- WO 0026973 A
- US 20180236756 A
- US 20180136755 A
- US 20180244881 A
- US 9790396 B
- US 10227688 B
- US 20150194541 A
- US 20120199198 A
- US 8128779 B


### Non-patent literature cited in the description


- **D. G. SHAW** ; **M. G. LANGLOIS**. A New Vapor Deposition Process for Coating Paper and Polymer Webs. *6th International Vacuum Coating Conference*, 1992
- **D. G. SHAW** ; **M. G. LANGLOIS**. A New High Speed Process for Vapor Depositing Acrylate Thin Films: An Update. *Society of Vacuum Coaters 36th Annual Technical Conference Proceedings*, 1993
- **D. G. SHAW** ; **M. G. LANGLOIS**. Use of Vapor Deposited Acrylate Coatings to Improve the Barrier Properties of Metallized Film. *Society of Vacuum Coaters 37th Annual Technical Conference Proceedings*, 1994
- **D. G. SHAW** ; **M. ROEHRIG** ; **M. G. LANGLOIS** ; **C. SHEEHAN**. Use of Evaporated Acrylate Coatings to Smooth the Surface of Polyester and Polypropylene Film Substrates. *RadTech*, 1996
- **J. AFFINITO** ; **P. MARTIN** ; **M. GROSS** ; **C. CORONADO** ; **E. GREENWELL**. Vacuum deposited polymer/metal multilayer films for optical application. *Thin Solid Films*, 1995, vol. 270, 43-48
- **J.D. AFFINITO** ; **M. E. GROSS** ; **C. A. CORONADO** ; **G. L. GRAFF** ; **E. N. GREENWELL** ; **P. M. MARTIN**. Polymer-Oxide Transparent Barrier Layers. *Society of Vacuum Coaters 39th Annual Technical Conference Proceedings*, 1996
- *CHEMICAL ABSTRACTS*, 25190-06-1
- *CHEMICAL ABSTRACTS*, 77-58-7
- *CHEMICAL ABSTRACTS*, 23328-53-2
- *CHEMICAL ABSTRACTS*, 41556-26-7
- *CHEMICAL ABSTRACTS*, 82919-37-7
- *CHEMICAL ABSTRACTS*, 2082-79-3